(19) **Europäisches Patentamt / European Patent Office / Office européen des brevets**

(11) **EP 4 687 025 A1**

(12) **EUROPEAN PATENT APPLICATION**

(43) Date of publication:
**04.02.2026 Bulletin 2026/06**

(21) Application number: **25192929.5**

(22) Date of filing: **30.07.2025**

(51) International Patent Classification (IPC):
**G06F 7/544** (2006.01)  **G06F 17/00** (2019.01)
**G06F 9/30** (2018.01)  **G06F 17/16** (2006.01)
**G06F 9/00** (2006.01)  **G06F 5/00** (2006.01)
**G06F 7/76** (2006.01)  H03M 7/04 (2006.01)

(52) Cooperative Patent Classification (CPC):
**G06F 7/5443; G06F 9/30018; G06F 9/30036;
G06F 17/16;** G06F 7/76; H03M 7/04

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **02.08.2024 US 202418793374**

(71) Applicant: **GDM Holding LLC
Mountain View CA 94043 (US)**

(72) Inventor: **Schmit, Herman Henry
Mountain View, 94043 (US)**

(74) Representative: **Varley, James Richard
Venner Shipley LLP
200 Aldersgate
London EC1A 4HD (GB)**

(54) **VARIABLE-BITWIDTH MATRIX MULTIPLICATION**

(57)   Systems and methods for performing variable-bitwidth matrix multiplication are provided. For example, a processor device can include dot product hardware configured to perform a plurality of dot products at a first bitwidth to generate a plurality of first-bitwidth dot product outputs. The processor device can include programmable adder hardware. The programmable adder hardware can be configured to obtain data indicative of one or more target bitwidths. The programmable adder hardware can be configured to combine, based on the data indicative of the one or more target bitwidths, one or more subsets of the plurality of first-bitwidth dot product outputs according to the one or more target bitwidths.

FIG. 9

EP 4 687 025 A1

## Description

FIELD

The present disclosure relates generally to computing devices, systems, and methods. More particularly, the present disclosure relates to devices, systems and methods for performing variable-bitwidth matrix multiplication.

BACKGROUND

A matrix is an ordered plurality of numbers, wherein each number of the ordered plurality of numbers is associated with a position in the matrix. For example, a two-dimensional matrix can be arranged into rows and columns, with each number of the ordered plurality of numbers being associated with a row position and a column position. As another example, each entry of a one-dimensional matrix (sometimes referred to as a "vector") may have a one-dimensional position in the matrix. Similarly, each entry of a three- or more-dimensional matrix (sometimes referred to as a "tensor") may be characterized by a three- or more-dimensional position (e.g., comprising a row position, column position, "depth" or "layer" position, etc.).

Matrix multiplication is a method for combining a first matrix and second matrix to generate a matrix product. Matrix multiplication can be useful for a variety of applications, such as machine learning, scientific computation, linear algebra, statistics, economics, and engineering.

A bit is a binary digit used as a basic unit to represent data in digital computation and digital communication. A single data item, such as a numerical value, can be represented by one bit or multiple bits. For example, a 16-bit integer is a numerical value represented by 16 bits. As another example, a 32-bit floating-point value is a numerical value represented by 32 bits of binary data. A bitwidth (sometimes referred to as a "precision") of a data item is a number of bits used to represent the data item. For example, a 16-bit integer has a bitwidth of 16, and a 32-bit floating-point value has a bitwidth of 32.

SUMMARY

Aspects and advantages of embodiments of the present disclosure will be set forth in part in the following description, or can be learned from the description, or can be learned through practice of the embodiments.

Example aspects of the present disclosure provide an example processor device. **In** some implementations, the example processor device can include dot product hardware configured to perform a plurality of dot products at a first bitwidth to generate a plurality of first-bitwidth dot product outputs. **In** some implementations, the example processor device can include programmable adder hardware. **In** the example processor device, the programmable adder hardware can be configured to obtain data indicative of one or more target bitwidths. **In** the example processor device, the programmable adder hardware can be configured to combine, based on the data indicative of the one or more target bitwidths, one or more subsets of the plurality of first-bitwidth dot product outputs according to the one or more target bitwidths.

In the example processor device, the first bitwidth can be one bit.

In the example processor device, the one or more target bitwidths can include at least one of: a first target bitwidth applicable to a first input matrix associated with the plurality of dot products and a second target bitwidth applicable to a second input matrix associated with the plurality of dot products; or a single target bitwidth applicable to both of a first and second input matrix associated with the plurality of dot products.

In the example processor device, the plurality of dot products can include $n^2$ dot products, wherein $n$ is a ratio of a maximum bitwidth supported by the processor device to the first bitwidth. In the example processor device, the plurality of first-bitwidth dot product outputs can include $n^2$ outputs corresponding to an $n \times n$ matrix product of an $n \times p$ first input matrix and a $p \times n$ second input matrix, wherein $p$ is a positive integer.

In the example processor device, each of $n$ rows of the $n \times p$ first input matrix can be associated with $m$ bit positions of a first plurality of $p$ input values, wherein $m$ is the first bitwidth and each of the $p$ input values has a bitwidth equal to the maximum bitwidth supported by the processor device. In the example processor device, each of $n$ columns of the $p \times n$ second input matrix can be associated with $m$ bit positions of a second plurality of $p$ input values having a bitwidth equal to the maximum bitwidth supported by the processor device.

In the example processor device, combining the plurality of first-bitwidth dot product outputs according to the one or more target bitwidths can include: if each of the one or more target bitwidths is equal to the first bitwidth, summing $n$ first-bitwidth dot product outputs of the plurality of first-bitwidth dot product outputs to generate a scalar first-bitwidth matrix multiplication output.

In the example processor device, summing the $n$ first-bitwidth dot product outputs can include performing a trace operation on the $n \times n$ matrix product.

In the example processor device, combining the plurality of first-bitwidth dot product outputs according to the target bitwidth can include: if at least one target bitwidth of the one or more target bitwidths is greater than the first bitwidth, combining one or more groups of first-bitwidth dot product outputs to generate one or more second-bitwidth dot product outputs corresponding to a second bitwidth that is greater than the first bitwidth.

In the example processor device, combining the one or more groups of first-bitwidth dot products can include scaling each respective first-bitwidth dot product output of the group of dot products by a factor of $2^q$, wherein $q$ corresponds to a sum of one or more distances between one or more bit positions associated with the respective first-bitwidth dot product output and one or more corresponding least significant bit positions; and summing the scaled first-bitwidth dot product outputs.

In the example processor device, combining the one or more groups of first-bitwidth dot products can include: if each of the of the one or more target bitwidths is equal to $2^k$ times the first bitwidth, wherein $k$ is an integer greater than or equal to zero, and if the maximum bitwidth supported by the processing device is equal to $2^{k+j}$ times the first bitwidth, wherein $j$ is an integer greater than or equal to zero: for each $r$th iteration of $k$ iterations, combining one or more groups of four dot product outputs having a bitwidth of $2^{r-1}$ times the first bitwidth to generate one or more dot product outputs having a bitwidth of $2^r$ times the first bitwidth; and if $2^k$ is less than n, summing $\dfrac{n}{2^k}$ dot product outputs of the one or more dot product outputs having a bitwidth of $2^k$ times the first bitwidth, wherein $n$ is a ratio of a maximum bitwidth supported by the processor device to the first bitwidth.

In the example processor device, summing the $\dfrac{n}{2^k}$ dot products can include performing a trace operation on an $\dfrac{n}{2^k} \times \dfrac{n}{2^k}$ matrix comprising the dot product outputs having the bitwidth of $2^k$ times the first bitwidth.

In the example processor device, the combining can include two's-complement arithmetic.

In the example processor device, the dot product hardware can include one or more systolic arrays for performing one or more first-bitwidth dot products.

In the example processor device, at least one of the dot product hardware and programmable adder hardware can be configured to perform bit-serial arithmetic.

In the example processor device, a number of total output bits associated with the plurality of dot products can be between 75 percent and 125 percent of a number of total input bits associated with the plurality of dot products.

Example aspects of the present disclosure provide an example method. In some implementations, the example method can include performing, by one or more processor devices, a plurality of dot products at a first bitwidth to generate a plurality of first-bitwidth dot product outputs. The example method can include obtaining, by the one or more processor devices, data indicative of one or more target bitwidths. The example method can include combining, by the one or more processor devices based on the data indicative of the one or more target bitwidths, one or more subsets of the plurality of first-bitwidth dot product outputs according to the one or more target bitwidths.

In the example method, combining the one or more subsets can include at least one of: if each of the one or more target bitwidths is equal to the first bitwidth, summing $n$ first-bitwidth dot product outputs of the plurality of first-bitwidth dot product outputs to generate a combined first-bitwidth dot product output, wherein $n$ is a ratio of a maximum bitwidth supported by the processor device to the first bitwidth; and if at least one target bitwidth of the one or more target bitwidths is greater than the first bitwidth, combining one or more groups of first-bitwidth dot product outputs to generate one or more second-bitwidth dot product outputs corresponding to a second bitwidth that is greater than the first bitwidth.

In the example method, the plurality of dot products can include $n^2$ dot products, wherein $n$ is a ratio of a maximum bitwidth supported by the processor device to the first bitwidth. In the example method, the plurality of first-bitwidth dot product outputs can include $n^2$ outputs corresponding to the plurality of dot products can include an $n \times n$ matrix product of a $p \times n$ first input matrix and an $n \times p$ second input matrix.

Example aspects of the present disclosure an example computing system. The example computing system can include one or more processor devices. In the example computing system, the one or more processor devices can include dot product hardware configured to perform a plurality of dot products at a first bitwidth to generate a plurality of first-bitwidth dot product outputs. In the example computing system, the one or more processor devices can include programmable adder hardware. In the example computing system, the programmable adder hardware can be configured to obtain data indicative of one or more target bitwidths. In the example computing system, the programmable adder hardware can be configured to combine, based on the data indicative of the one or more target bitwidths, one or more subsets of the plurality of first-bitwidth dot product outputs according to the one or more target bitwidths.

In the example computing system, combining the one or more subsets can include at least one of: if each of the one or more target bitwidths is equal to the first bitwidth, summing $n$ first-bitwidth dot product outputs of the plurality of first-bitwidth dot product outputs to generate a combined first-bitwidth dot product output wherein $n$ is a ratio of a maximum bitwidth supported by the processor device to the first bitwidth; and if at least one target bitwidth of the one or more target bitwidths is greater than the first bitwidth, combining one or more groups of first-bitwidth dot product outputs to generate one or more second-bitwidth dot product outputs corresponding to a second bitwidth that is greater than the first bitwidth.

Other example aspects of the present disclosure are directed to other systems, methods, apparatuses, tangible non-transitory computer-readable media, and devices for performing functions described herein. These and other features, aspects, and advantages of various implementations will become better understood with reference to the following description and appended claims. The accompanying drawings, which are incorporated in and constitute a part of this specification, illustrate implementations of the present disclosure and, together with the description, help explain the related principles.

BRIEF DESCRIPTION OF THE DRAWINGS

Figure 1A depicts an example bitwidth-eight matrix multiplication to be performed and introduces example notations and terminology for describing bit positions according to example implementations of aspects of the present disclosure;

Figure 1B depicts an example bitwidth-one matrix multiplication to be performed according to example implementations of aspects of the present disclosure, and illustrates how the example notations and terminology of Figure 1A may be used herein to describe operations across different bitwidths;

Figure 2A depicts an example visual diagram illustrating one or more example partial product operations according to example implementations of aspects of the present disclosure;

Figure 2B depicts an example visual diagram illustrating an example plurality of example partial products according to example implementations of aspects of the present disclosure;

Figure 3A depicts an example dot product operation according to example implementations of aspects of the present disclosure;

Figure 3B depicts an example matrix comprising a plurality of example outputs of a plurality of example dot products according to example implementations of aspects of the present disclosure;

Figure 4 depicts an example operation for combining one or more dot products according to example implementations of aspects of the present disclosure;

Figure 5 depicts an example operation for combining one or more dot products according to example implementations of aspects of the present disclosure;

Figure 6 depicts an example operation for combining one or more dot products according to example implementations of aspects of the present disclosure;

Figure 7 depicts an example operation for combining one or more dot products according to example implementations of aspects of the present disclosure;

Figure 8 depicts an example matrix multiplication according to example implementations of aspects of the present disclosure;

Figure 9 depicts an example hardware configuration for performing matrix multiplication according to example implementations of aspects of the present disclosure;

Figure 10 depicts example hardware for performing matrix multiplication according to example implementations of aspects of the present disclosure; and

Figure 12 is a block diagram of an example networked computing system according to example implementations of aspects of the present disclosure.

DETAILED DESCRIPTION

Generally, the present disclosure is directed to systems and methods for performing variable-bitwidth matrix multiplication. For example, a processor device can receive a first plurality of bits representing a first plurality of numbers of a first input matrix; a second plurality of bits representing a second plurality of numbers of a second input matrix; and one or more bitwidth inputs indicating a bitwidth of the first plurality of numbers or second plurality of numbers. Based on the bitwidth inputs and the first and second pluralities of bits, the processor device can perform a matrix multiplication of the first input matrix and the second input matrix. As a non-limiting illustrative example, a processor may be configured to receive a 1024-bit first plurality of bits; a 1024-bit second plurality of bits; and bitwidth data indicating whether each 1024-bit input represents 1024 one-bit numbers (i.e., 1024 numbers having a bitwidth of one); 512 two-bit numbers; 256 four-bit numbers; 128 eight-bit numbers; or the like.

In some instances, a processing device can perform variable-bitwidth matrix multiplication by first performing a plurality of low-bitwidth (e.g., one-bit, etc.) dot product operations, and subsequently combining the dot products based on the bitwidth input indicating the bitwidth of each input matrix. For example, continuing the non-limiting illustrative example described above, if a processor device is configured to receive 1024-bit first and second input bitstrings and bitwidth values between one and eight, the processor device can divide each 1024-bit input into eight groups of 128 one-bit values; perform 64 (i.e., eight times eight) dot products, wherein each dot product combines one of the eight first-input groups with one of the eight second-input groups; and subsequently combine the dot products based on the bitwidth inputs indicating the bitwidth of the first and second inputs. Performing a dot product can include multiplying (or performing an equivalent operation, such as a bitwise "and" operation for 1-bit multiplications) each of the 128 values of the first group with a corresponding value of the second group (e.g., a value in the same position in a second-group vector, etc.), and adding up the 128 multiplied values.

In some instances, the outputs of the plurality of dot products can constitute a valid matrix multiplication result as-is (e.g., without combining any dot products). For example, continuing the non-limiting illustrative example where a processor device is configured to perform 64 dot product operations, the outputs of the dot product operations can constitute an 8 by 8 two-dimensional matrix output, which can be a valid matrix product of a first 8 x 128 input matrix and a second 128 x 8 input matrix comprising one-bit numerical values.

However, in some instances, the outputs of the plurality of dot products can be combined to generate matrix multiplication results of other matrix multiplication operations (e.g., vector product of 1024 x 1 and 1 x 1024 vectors of one-bit values; matrix product of two-bit, four-bit, or eight-bit values; etc.). For example, the dot products can be combined in a first way (e.g., a trace operation as described below) to alter the shape of the input and output matrices without altering the bitwidth (e.g., converting an 8 x 8 output of a 128 x 8 matrix multiplication to a 4 x 4 output of a 256 x 4 multiplication or single-number output of a 1024 x 1 multiplication, etc.). As another example, the dot products can be combined in a second way (e.g., scaling dot products based on bit position and summing the scaled values) to generate a higher-bitwidth matrix multiplication result (e.g., combining one-bitwidth dot products to generate two-bitwidth, four-bitwidth, and eight-bitwidth matrix multiplication outputs, etc.).

As an example of the first type of combination, in some instances, a one-dimensional vector product can be determined by performing a trace operation on a matrix comprising the plurality of dot product outputs. A trace operation can include adding up all outputs along a diagonal of a square matrix of dot product outputs. For example, continuing the non-limiting illustrative example involving 1024 one-bit numbers, a trace operation can include adding up all dot product outputs where the first-input group and second-input group share the same bit positions in their respective input bitstrings. For example, a group of the first input matrix might include the first bit, ninth bit, seventeenth bit, $25^{th}$ bit, and so on of the first 1024-bit input string (i.e., every eighth bit starting with the first), and a corresponding group of the second input matrix might include the first bit, ninth bit, seventeenth bit, and so on of the second 1024-bit input string. In some instances, a trace operation can include adding dot products where the groups being multiplied shared the same corresponding bit positions, and discarding values where the groups being multiplied do not share the same corresponding positions.

As an example of the second type of combination, a two-bitwidth matrix multiplication output can be generated based on one-bit dot products by scaling each dot product based on one or more bit positions associated with the dot product, and adding one or more scaled values to generate the two-bitwidth matrix multiplication result. A bit position can be, for example, a position of a bit within a binary representation of a number, which can be analogous to a position of a digit in a decimal representation of a number. As an illustrative example, the decimal number 537 has a "5" in the "hundreds" position, a "3" in the "tens" position, and a "7" in the "ones" position, adding up to 500 + 30 + 7 = 537. Similarly, the five-bit binary number 11001 can be thought of as having a one in the "sixteens" position, a one in the "eights" position, a zero in the "fours" position, a zero in the "twos" position, and a one in the "ones" position, representing a numerical value of 16 + 8 + 1 = 25. In some instances, the input bits used in the dot products can be grouped by bit position. For example, continuing the non-limiting illustrative example involving 1024-bit inputs, the 1024-bit inputs can be split into a first group of 128 bits that would fall in the "ones" position if the 1024-bit input was treated as 128 eight-bit numbers; a second group of 128 bits that would fall in the "twos" position of a corresponding eight-bit number; a third group of 128 bits that would fall in the "fours" position of a corresponding eight-bit number; and so on.

In some instances, each dot product output can be scaled based on a bit position of each of two groups used to generate the dot product. For example, if a dot product is generated based on two groups in the "ones" position, the dot product can be left unchanged or multiplied by one (i.e., one times one). As another example, if a dot product is generated based on a first group in the "ones" position and a second group in the "twos" position, the dot product can be doubled (i.e., multiplied by two times one). As another example, if a dot product is generated based on two groups in the "twos" position, the dot product can be quadrupled (i.e., multiplied by two times two). Similar scaling can be performed for dot products based on groups in the "fours" position, "eights" position, or any other bit position. In some instances, scaling a dot product output represented in a binary format can include left-shifting the binary representation based on a sum of the bit positions of the input groups used to determine the dot product.

In some instances, a processing device can include specialized hardware for generating and combining the dot product outputs. For example, in some instances, a processing device can have one or more dedicated dot product units to generate the dot products, and one or more programmable adder units to combine the dot products. In some instances, the dot product units can include non-programmable fixed-operation units to perform the dot product operations the same way every time. For example, in some instances, the dot product units can include one or more systolic arrays to perform the dot product operations the same way every time. The programmable adder unit can include, for example, a programmable logic device configured to perform different operations depending on one or more inputs it receives, such as one or more bitwidth inputs indicating a bitwidth for the matrix multiplication operation. For example, the programmable adder unit can combine dot product outputs in different ways depending on one or more target bitwidths associated with a matrix multiplication operation being performed. In some instances, the processing device can include additional components (e.g., memory components, input/output components, interconnections between components, additional arithmetic units for performing other operations, etc.). In some instances, the processing device can be a component of a computing device comprising one or more processor devices.

Systems and methods according to example aspects of the present disclosure can provide a variety of technical effects and benefits, such as reduced computational cost (e.g., electricity cost, memory usage, processor usage, etc.), reduced hardware device footprint (e.g., area in square micrometers, etc.), reduced hardware cost, reduced latency, and improved computational flexibility compared to some alternative implementations.

For example, in some example simulations according to some aspects of the present disclosure, a device manufacturing process was simulated for manufacturing example variable-bitwidth matrix multiplication hardware according to the present disclosure; alternative variable-bitwidth matrix multiplication hardware; and fixed-bitwidth matrix multiplication hardware. In the example simulations, some example variable-bitwidth matrix multiplication hardware according to the present disclosure had an area of 2664 square micrometers and a maximum topological depth of 50. In contrast, example alternative hardware (e.g., alternative single-instruction multiple-data hardware) for performing variable-bitwidth matrix multiplication had an area of 4515 square micrometers and a maximum topological depth of 158.

This reduction in device footprint area and topological depth can provide a variety of technical benefits. For example, topological depth can in some instances be correlated with computational latency, as data that must pass through a large number of processing steps or hardware components may take longer to do so than data that must pass through a smaller number of processing steps. Thus, a sharp reduction in topological depth can in some instances provide a corresponding reduction in computational latency.

As another example, a reduction in device footprint area can in some instances provide a variety of technical effects and benefits, such as reduced computational cost, reduced hardware cost, or improved hardware performance compared to some alternative devices. For example, in some instances, a cost to manufacture a hardware device may be correlated with a footprint area of the hardware device. For example, in some instances, a reduced device footprint area can enable manufacturing more devices per wafer on a given wafer size, thereby reducing a per-device cost of manufacturing. As another example, a computational cost (e.g., electricity cost, memory usage, etc.) associated with matrix multiplication may in some instances be correlated with a number of processing steps performed; an amount of intercommunication that must be performed between device components; and the like. In such instances, reducing a circuit footprint and topological depth of a variable-bitwidth matrix multiplication device can reduce a computational cost of performing variable-bitwidth matrix multiplication compared to some alternative methods. As another example, reducing a device footprint may in some instances open up additional space to add other devices (e.g., additional variable-bitwidth matrix multiplication units, devices having different device types, etc.) to a processor or chip. Such additional devices can in some instances perform functions that may improve hardware performance (e.g., latency, throughput, etc.) of a processor in various ways, such as reducing one or more memory bottlenecks or intercommunication bottlenecks, performing additional arithmetic operations (e.g., activation function operations, matrix multiplication operations, etc.), or other functions.

As another example, systems and methods according to example aspects of the present disclosure can in some instances provide improved flexibility compared to some alternative systems and methods. For example, some alternative hardware devices may perform fixed-bitwidth matrix multiplication, thereby reducing a number of bitwidth options compared to example variable-bitwidth matrix multiplication devices of the present disclosure. In some instances, such increased flexibility can also lead to additional technical effects and benefits, such as reduced hardware cost. For example, performing matrix multiplication in multiple bitwidths on fixed-bitwidth hardware devices may in some instances require including multiple fixed-bitwidth matrix multiplication devices on a single chip, thereby increasing a hardware cost compared to some example implementations of aspects of the present disclosure.

Various example implementations are described herein with respect to the accompanying Figures.

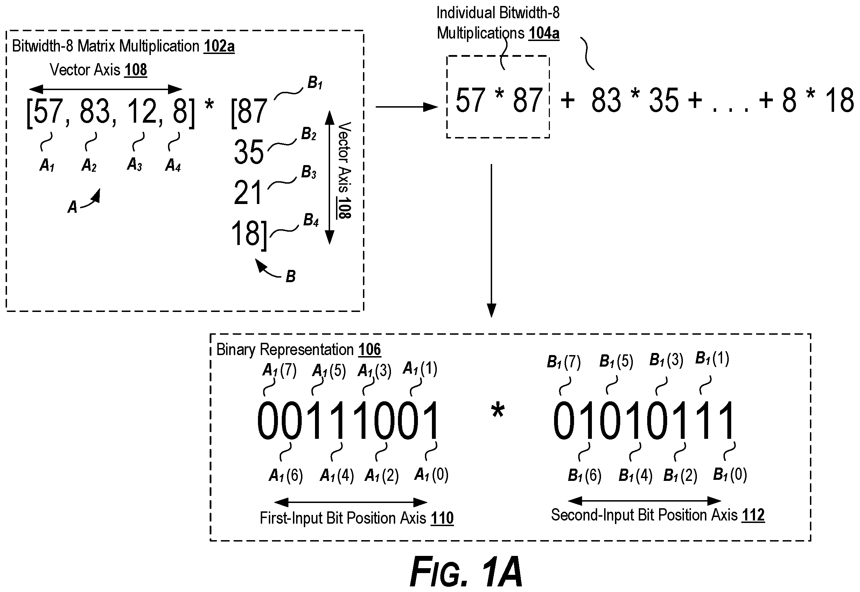

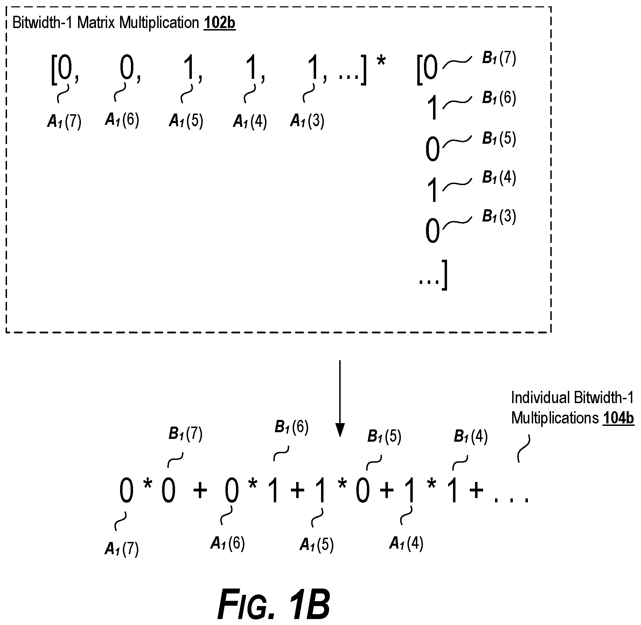

Figures 1A and 1B depict two example matrix multiplications to be performed at different bitwidths, and illustrates how notation used herein can be used to describe matrix multiplications of different bitwidths.

Figure 1A depicts an example bitwidth-eight matrix multiplication to be performed and introduces example notations and terminology for describing bit positions according to example implementations of aspects of the present disclosure. A bitwidth-8 matrix multiplication 102 can include a matrix multiplication between a first input matrix $A$ comprising a plurality of entries $A_1$, $A_2$, $A_3$, and $A_4$ and a second input matrix $B$ having a plurality of entries $B_1$, $B_2$, $B_3$, and $B_4$. An output of the bitwidth-8 matrix multiplication 102 can be equal to a sum of individual multiplications 104, wherein each individual multiplication 104 corresponds to multiplying a first-input-matrix entry $A_i$ by a corresponding second-input-matrix entry $B_i$.

As illustrated in Figure 1A, each entry $A_1$, $A_2$, $A_3$, $A_4$, $B_1$, $B_2$, $B_3$, and $B_4$ can be an eight-bit number. Each eight-bit number can be represented by binary representation 106 having eight bits in bit positions numbered zero through seven. For example, Figure 1A depicts the binary representation 106 of entry $A_1$ having eight bits, with the least significant bit (i.e., the bit in the

"ones" position) labeled $A_1$ (0), the second least significant bit (i.e., the bit in the "twos" position) labeled $A_1$ (1), and so on, with the most significant bit (i.e., the bit in the "one-hundred-twenty-eights" position) labeled $A_1$ (7).

However, although the entries depicted in Figure 1A are eight-bit entries for use in a bitwidth-8 matrix multiplication, the term "entry" as used herein does not necessarily refer to a number having a bitwidth associated with a matrix multiplication *actually being performed* at any given moment (e.g., in any given figure depicted herein). Instead, the notation used herein may use the term "entry," along with corresponding entry labels such as $A_1$, $A_2$, $A_3$, $A_4$, $B_1$, $B_2$, $B_3$, and $B_4$, to refer to a number of bits equal to a maximum depicted bitwidth. As an illustrative example, Figures 1A and 1B depicts operations that may be performed by a variable-bitwidth processing device having a maximum supported bitwidth of 8 and a minimum supported bitwidth of 1. In such a depiction, the term "entry" can be used herein to refer to a group of eight consecutive bits in an input bitstring or input matrix. As an illustrative example, entry $A_1$ can correspond to the first eight bits of first-input-matrix $A$; $A_2$ can correspond to the ninth through sixteenth bits of first-input-matrix $A$; and so on.

Although Figures 1A and 1B depict operations that can be performed by a processor having a maximum supported bitwidth of 8 and a minimum supported bitwidth of 1, these bitwidth values are provided by way of example only, and are not intended to be limiting. For example, processing devices according to aspects of the present disclosure can support any combination of minimum and maximum bitwidth, such as a maximum bitwidth of 2, 3, 4, 6, 8, 12, 16, 32, 64, or any number greater than 1; and such as a minimum supported bitwidth of 1, 2, 3, 4, 6, 8 or any number less than a corresponding maximum supported bitwidth. Additionally, any notations and terminology introduced in Figures 1A through 2C are provided by way of illustration and explanation only, and the notations and terminology used herein (e.g., entry-position notations, bit position notations, visual diagrams, etc.) should not be construed to limit the scope of the present disclosure.

Figure 1A further depicts three axes 108, 110, and 112 to assist in a reader's understanding of one or more visual diagrams that may be used in later Figures.

For example, Figure 1A depicts a vector axis 108 that is applicable to both the first input matrix $A$ and the second input matrix $B$. The vector axis 108 can be an axis defining a position of each entry $A_1$, $A_2$, $A_3$, $A_4$, $B_1$, $B_2$, $B_3$, and $B_4$ within a respective input matrix $A$ or $B$. For example, entries $A_1$ and $B_1$ can be described as being in position one on the vector axis 108. However, as explained above, the "entries" along the vector axis 108 do not necessarily refer to entries having a bitwidth associated with a matrix multiplication *actually being performed* at any given moment (e.g., in any given figure depicted herein). Instead, a vector axis 108 as depicted herein can refer to an axis across entries such as $A_1$, $A_2$,

$A_3$, $A_4$, which can have a number of bits equal to a maximum depicted bitwidth. Thus, in the depictions of Figure 1A and 1B describing operations that may be performed by a variable-bitwidth processing device having a maximum supported bitwidth of 8 and a minimum supported bitwidth of 1, each "entry" can correspond to a group of eight bits, and a vector axis 108 as depicted herein can refer to an axis spanning across such eight-bit groups irrespective of a bitwidth of a matrix multiplication actually being performed.

As another example, Figure 1A depicts a first-input bit position axis 110 and a second-input bit position axis 112. Each of the first-input bit position axis 110 and a second-input bit position axis 112 can be an axis defining a position of an individual bit within an entry of a respective input matrix $A$ or $B$. For example, bit $A_1$ (0) can be described as being in position zero on the first-input bit position axis 110 and position one on the vector axis 108. However, as used herein, bit $A_1$ (0) does not have any position on the second-input bit position axis 112 because it is not part of the second input matrix $B$. Similarly, bit $B_1$ (3) can be described as being in position one on the vector axis 108, being in position three on the second-input bit position axis 112, and not having any position on the first-input bit position axis 110. Once again, as explained above, the entries $A_1$ and $B_1$ can refer herein to entries having a bitwidth associated with a maximum depicted bitwidth (e.g., maximum bitwidth supported by a particular processing device, etc.), irrespective of a bitwidth of a matrix multiplication actually being performed. Similarly, the bit position numbers used herein can refer to bit positions within each entry, wherein each entry may have a bitwidth associated with a maximum depicted bitwidth.

Figure 1B depicts a second example matrix multiplication to be performed, and illustrates how the notations and terminology used herein can be used to describe bit positions and vector positions with respect to operations of different bitwidths. These notations and terminology are provided by way of illustration and explanation only, and the notations and terminology used herein (e.g., bit-position and entry-position notations, etc.) should not be construed to limit the scope of the present disclosure.

Figure 1B depicts an example bitwidth-one matrix multiplication 102b to be performed on a plurality of input bits that can be similar to (e.g., same as) the input bits depicted in Figure 1A with respect to a bitwidth-8 matrix multiplication 102. For example, as depicted, each bit of the first input matrix A depicted in Figure 1B with respect to a bitwidth-1 matrix multiplication 102b may be identical to each bit of the first input matrix A depicted in Figure 1A with respect to a bitwidth-8 matrix multiplication 102.

Comparing Figure 1B to 1A, it will be appreciated that each depicted bit is labeled with the same notation regardless of the bitwidth of the matrix multiplication to be performed. For example, the leftmost bit of each first input matrix **A** is labeled $A_1$ (7), the next bit of each first input matrix **A** is labeled $A_1$ (6), and so on. Similarly, the ninth bit of each first input matrix **A** (not depicted in Figure 1B) would be labeled $A_2$ (7), as it would correspond to the most significant bit of a second eight-bit entry of an eight-bitwidth first input matrix **A**.

As used herein, an entry position on the vector axis 108 can be an entry position based on a maximum supported bitwidth of a depicted hardware device. For example, if a hardware device supports bitwidths between 1 and 32, then entry $A_1$ can be defined as the first 32 bits of a first input matrix **A**; if a hardware device supports bitwidths from 2 to 8, then entry $A_1$ can be defined as the first 8 bits of a first input matrix **A**; and so on. Similarly, as used herein, a bit position on a bit position axis 110, 112 can be a bit position based on a maximum supported bitwidth of a depicted hardware device. For example, if a hardware device supports bitwidths between 1 and 32, then the eighth bit of a first input matrix **A** can be labeled as bit $A_1$ (24); in contrast, if a hardware device supports bitwidths from 2 to 8, then the eighth bit of the first input matrix **A** can be labeled as bit $A_1$ (0).

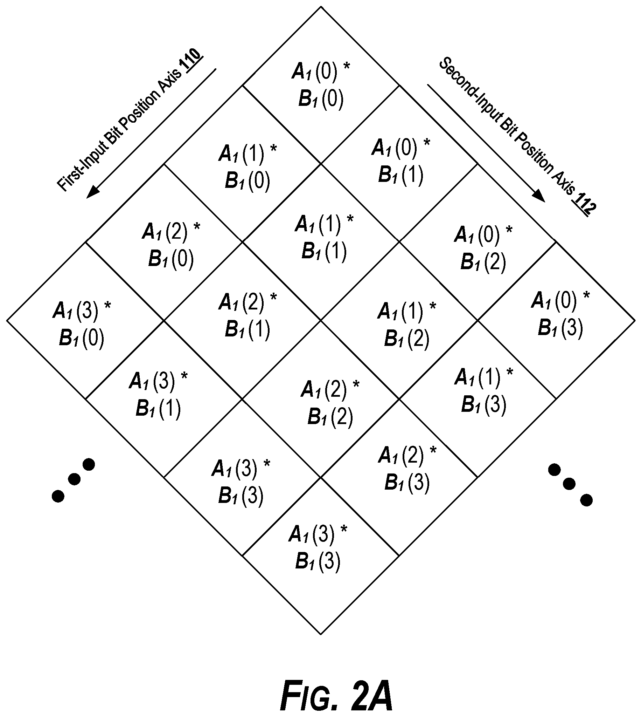

Figure 2A depicts an example visual diagram illustrating one or more example partial product operations according to example implementations of aspects of the present disclosure. In the example partial product operations, a plurality of bits of a first-input-matrix A entry (e.g., $A_1$, etc.) can be divided into a plurality of subsets (e.g., one-bit subsets, two-bit subsets, etc.); a plurality of input bits of a corresponding second-input matrix **B** entry (e.g., $B_1$ if the first-matrix entry is $A_1$, $B_2$ if $A_2$, etc.) can be divided into a plurality of subsets (e.g., one-bit subsets, two-bit subsets, etc.); and each subset of the fist-input-matrix **A** entry can be separately multiplied by each subset of the second-input-matrix **B** entry. For example, as depicted, entries $A_1$ and $B_1$ are divided into eight 1-bit groups (only four of which are shown) and separately multiplied to generate an 8 x 8 grid (a 4 x 4 portion of which is shown). In some instances, each subset of an entry can have a bitwidth less than or equal to a minimum supported bitwidth of a variable-bitwidth matrix processing device. For example, if a minimum supported bitwidth is one, then each subset can be a one-bit subset; if a minimum supported bitwidth is two, then each subset can be a two-bit subset or one-bit subset; and so on. If multi-bit subsets are used, then the subset can in some instances be treated as multi-bit numbers having a bitwidth equal to the number of bits in the subset.

In the diagram of Figure 2A, each small square (or small diamond shape) can represent a multiplication (e.g., bitwise "and" operation between one-bit subsets, etc.) between a first-input subset on the first-input bit position axis 110 and a second-input subset on the second-input bit position axis 112. For example, as depicted, the subsets can be one-bit subsets, and the topmost small square can represent a bitwise multiplication of $A_1$ (0) * $B_1$ (0). Moving down the top-right edge of the large square in the direction of the second-input bit position axis 112, the next squares can represent bitwise multiplications of $A_1$ (0) * $B_1$ (1), $A_1$ (0) * $B_1$ (2), and $A_1$ (0) * $B_1$ (3). Similarly, moving from the $A_1$ (0) * $B_1$ (0) square down the top-left edge in the direction of the first-input bit position axis 110, the next squares represent bitwise multiplications of $A_1$ (1) * $B_1$ (0), $A_1$ (2) * $B_1$ (0), and $A_1$ (2) * $B_1$ (0). Thus, it will be understood that each subset (e.g., one-bit subset) of $A_1$ can be separately multiplied by each subset (e.g., one-bit subset) of $B_1$, and the corresponding results of the plurality of subset multiplications (e.g., bitwise multiplications) can be visually depicted as a grid of partial products (e.g., bitwise multiplication results).

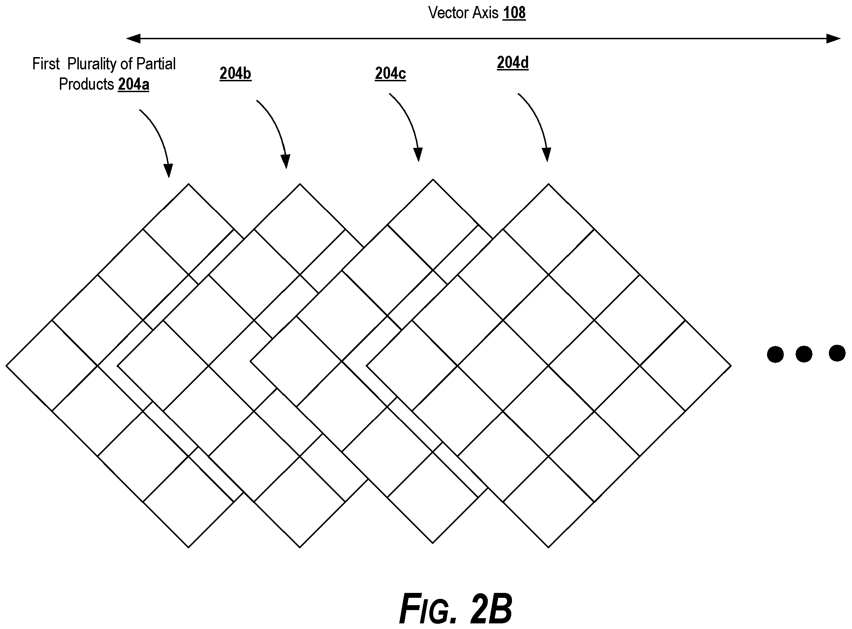

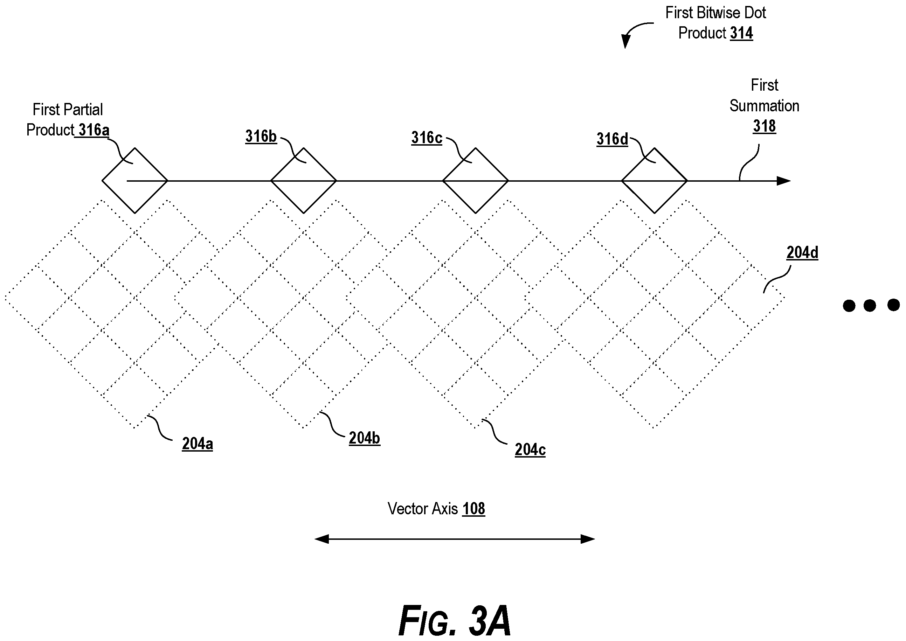

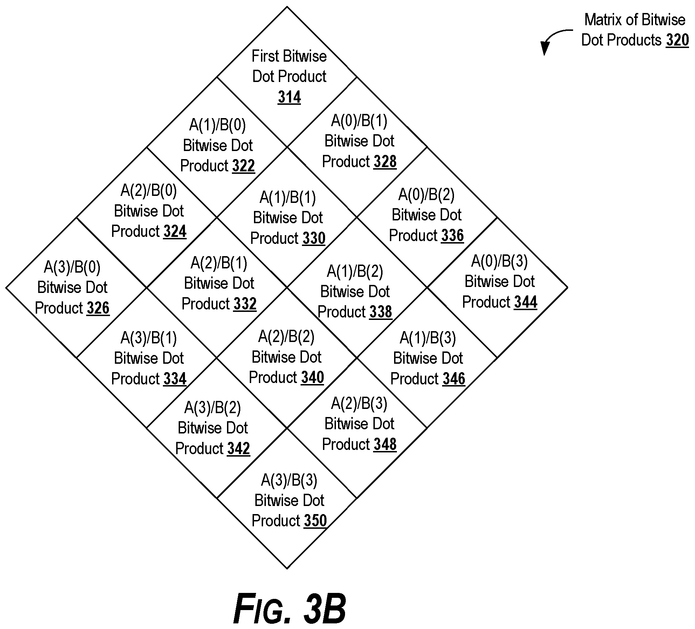

The subset multiplications depicted in Figure 2A can be performed in any appropriate manner for determining an output that is equal to a product of a first subset of bits and second subset of bits. For example, in some instances, a circuit for performing a plurality of partial products associated with one-bit subsets can include one or more bitwise-and circuits (e.g., AND gates, logic circuit comprising plurality of AND gates, etc.), wherein each bitwise-and circuit can perform a bitwise and operation on one or more pairs of bits (e.g., one, two, four, eight, 16, or 32 pairs, etc.). As another example, a device for performing a plurality of partial products associated with multi-bit subsets can include one or more devices for performing multi-bit multiplication (e.g., binary multiplier circuits, arithmetic logic units or components thereof, etc.). In some instances, circuits for performing the subset multiplications depicted in Figure 2A can be components of a systolic array, such as a systolic array for performing a plurality of operations described herein with respect to Figures 2A, 2B, 3A, and 3B.

Figure 2B depicts an example diagram illustrating an example plurality of example partial products according to example implementations of aspects of the present disclosure. For example, each large square (or large diamond shape) of Figure 2B can correspond to a grid of partial products as described above with respect to Figure 2A, with each separate grid corresponding to separate pairs of corresponding entries $A_i$ and $B_i$. For example, a first plurality of partial products 204a can correspond to partial products performed as described above with respect to $A_1$ and $B_1$; a second plurality of partial products 204b can correspond to partial products performed as described above with respect to $A_2$ and $B_2$; a third plurality of partial products 204c can correspond to partial products performed as described above with respect to $A_3$ and $B_3$; a fourth plurality of partial products 204d can correspond to partial products performed as described above with respect to $A_4$ and $B_4$; and so on.

Figure 3A depicts an example dot product according to example implementations of aspects of the present disclosure. A first bitwise dot product 314 can correspond to a first summation 318 of a first partial product 316a, second partial product 316b, third partial product 316c, fourth partial product 316d, and so on. For example, in some instances, a number of partial products summed can be equal to a number of entries of each input matrix **A** and **B** (e.g., 128 if input matrix **A** and input matrix **B** each have 128 entries, etc.).

Each partial product 316a-d of a first bitwise dot product 314 can include, for example, a partial product result determined by multiplying a least-significant-bit subset of a first input matrix **A** entry and second input matrix **B** entry. For example, in the case of a partial products 204a-d determined based on one-bit subsets, a partial product 316a-d can include a bitwise multiplication (e.g., bitwise and operation, etc.) of a least significant bit of a first input matrix **A** entry and a least significant bit of a corresponding second input matrix **B** entry. For example, a first partial product 316a can be equal to $A_1 (0) * B_1 (0)$; a second partial product 316b can be equal to $A_2 (0) * B_2 (0)$; a third partial product 316c can be equal to $A_3 (0) * B_3 (0)$; a fourth partial product 316d can be equal to $A_4 (0) * B_4 (0)$; and so on.

A summation 318 can include any method for determining a value equal to a sum of partial products 316 (e.g., adder circuits, arithmetic logic units, etc.). For example, in some instances, a summation 318 can include one or more adder circuits for adding some or all of the partial products 316. In sum instances, one or more circuits for performing a summation 318 can include circuits for performing serial addition (e.g., bit-serial addition, etc.) or parallel addition (e.g., bit parallel addition, etc.). In some instances, a summation 318 can be performed by one or more multi-input adder circuits (e.g., carry-save adder circuits, etc.) configured to sum more than two partial products 316; a plurality of two-input adder circuits that may hierarchically sum the partial products 316; or other circuit configuration. For example, in some instances, a summation 318 can be performed by one or more carry-save adder circuits configured to perform bit-serial addition. As another example, in some instances, hierarchically summing the partial products can include hierarchically summing according to a tree structure. For example, a tree structure can include a first layer of adder circuits to add two or more partial products 316; a second layer of adder circuits to add the sums generated by the first layer; and so on. In some instances, one or more components (e.g., adder circuits) for performing a first summation 318 can be components of a systolic array (e.g., systolic array comprising first components for determining partial products 316a-d, 204a-d, etc. and second components for performing summations 318).

Figure 3B depicts an example matrix of bitwise dot products 320 comprising a plurality of example outputs of a plurality of example dot products according to example implementations of aspects of the present disclosure. For example, Figure 3A depicts performing a first summation 318 of a plurality of least-significant-bit partial products to generate a first bitwise dot product 314. Operations similar to (e.g., same as) the operations described above with respect to Figure 3A can be performed on a plurality of pairs of bit-position subsets to generate a plurality of dot products 314, 322-350 associated with a plurality of bit positions. For example, an **A** (1)/**B** (0) bitwise dot product 322 can comprise a summation 318 of a plurality of pairs of entries associated with an **A** (1) bit position (i.e., first-input-matrix **A** entries having a bit position of one on a first-input bit position axis 110) and a **B** (0) bit position (i.e., second-input matrix **B** entries having a bit position of zero on a second-input bit position axis 112). For example, an **A** (1)/**B** (0) bitwise dot product 322 can comprise a sum of $A_1 (1) * B_1 (0) + A_2 (1) * B_2 (0) + A_3 (1) * B_3 (0) + \ldots + A_p (1) * B_p (0)$, where $p$ is a number of entries in each input matrix **A** and **B**. Similarly, any depicted dot product 324-350 can be associated with a first-input bit position and second-input bit position corresponding to the position of the dot product 324-350 in the matrix of bitwise dot products 320.

In some instances, a matrix of bitwise dot products 320 can include an $n \times n$ matrix, wherein n can be a maximum supported bitwidth (e.g., maximum bitwidth supported by a particular variable-bitwidth processing device, etc.) or a ratio between a maximum supported bitwidth and a minimum supported bitwidth. For example, in some instances, a $1 \times p$ first input matrix **A,** wherein each entry is characterized by the maximum supported bitwidth, can correspond to an $n \times p$ first input matrix **A',** wherein each entry of **A'** is characterized by the minimum supported bitwidth. Similarly, in some instances, a $p \times 1$ first input matrix **B,** wherein each entry is characterized by the maximum supported bitwidth, can correspond to a $p \times n$ second input matrix **B',** wherein each entry of **B'** is characterized by the minimum supported bitwidth. For example, in some instances, each column of an $n \times p$ first input matrix **A'** and each row of a $p \times n$ second input matrix **B'** can correspond to $m$ bit positions of a first input matrix **A** and second input matrix **B** respectively, wherein $m$ is a minimum supported bitwidth.

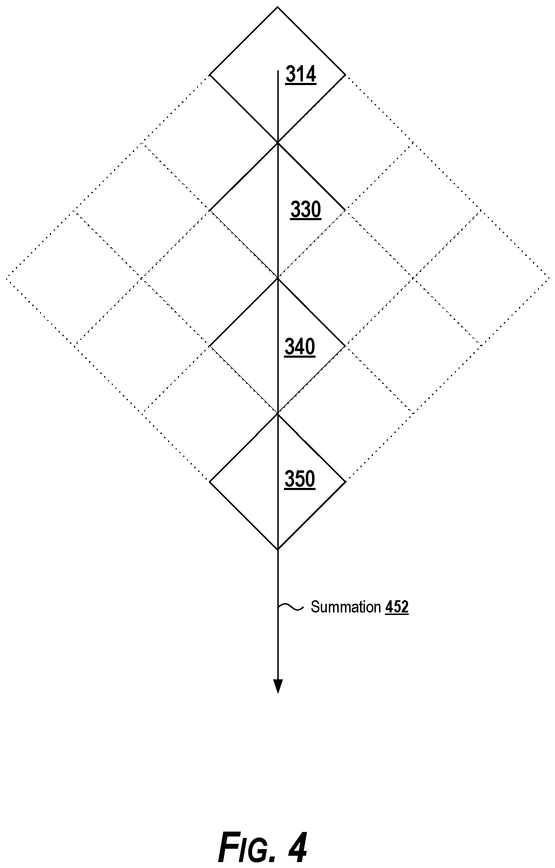

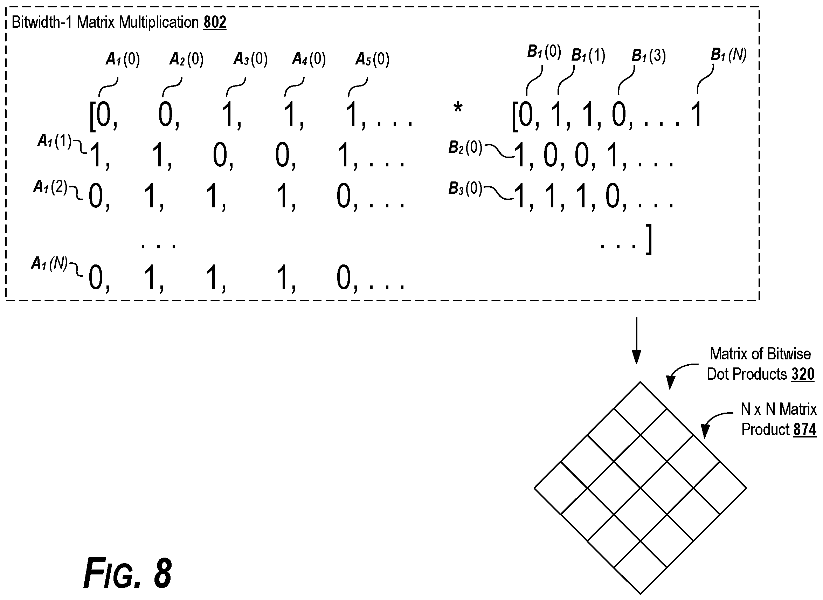

In some instances, an $n \times n$ matrix of bitwise dot products 320 can constitute a valid matrix multiplication result as-is for some example matrix multiplications. Further details of one such example matrix multiplication are provided below with respect to Figure 8. In other instances, dot products of a matrix of bitwise dot products 320 can be combined in various ways to generate a valid matrix multiplication result for other example matrix multiplications. Further details of some example combining operations according to aspects of the present disclosure are provided below with respect to Figures 4-7.

Figure 4 depicts an example operation for combining one or more dot products according to example implementations of aspects of the present disclosure. More particularly, Figure 4 depicts an example operation for combining dot products 314, 322-350 to generate a one-bitwidth (or minimum-supported-bitwidth) matrix multiplication output, wherein each input matrix A and B associated with the one-bitwidth matrix multiplication is a one-dimensional vector (i.e., one-row or one-column matrix). As depicted in Figure 4, a one-bitwidth matrix multiplication result can be determined by performing a summation 452 of a first bitwise dot product 314 (i.e., dot product associated with an $A$ (0) bit position and a $B$ (0) bit position), an $A$ (1)/$B$ (1) bitwise dot product 330, an $A$ (2)/$B$ (2) bitwise dot product 350, and an $A$ (3)/$B$ (3) bitwise dot product 350. This can be equivalent to performing a trace operation on the matrix of bitwise dot products 320. This can also be equivalent, for example, to summing a plurality of dot products 314, 330, 340, 350, wherein each dot product of the sum is associated with a first-input bit position that is equal to a corresponding second-input bit position associated with the dot product. For example, in some instances, a summation 452 can include summing $n$ first-bitwidth dot product outputs of the plurality of first-bitwidth dot product outputs to generate a scalar first-bitwidth matrix multiplication output, where $n$ can be a maximum supported bitwidth or a ratio between a maximum supported bitwidth and a minimum supported bitwidth.

In some instances, a summation 452 can be, comprise, be comprised by, or otherwise share one or more properties with a summation 318. For example, a summation 452 can have any property described above with respect to a summation 318, except that a different group of values is being summed. In some instances, a summation 452 can be performed using computer hardware (e.g., one or more adders, etc.) that is the same as or different from hardware used to perform a summation 318.

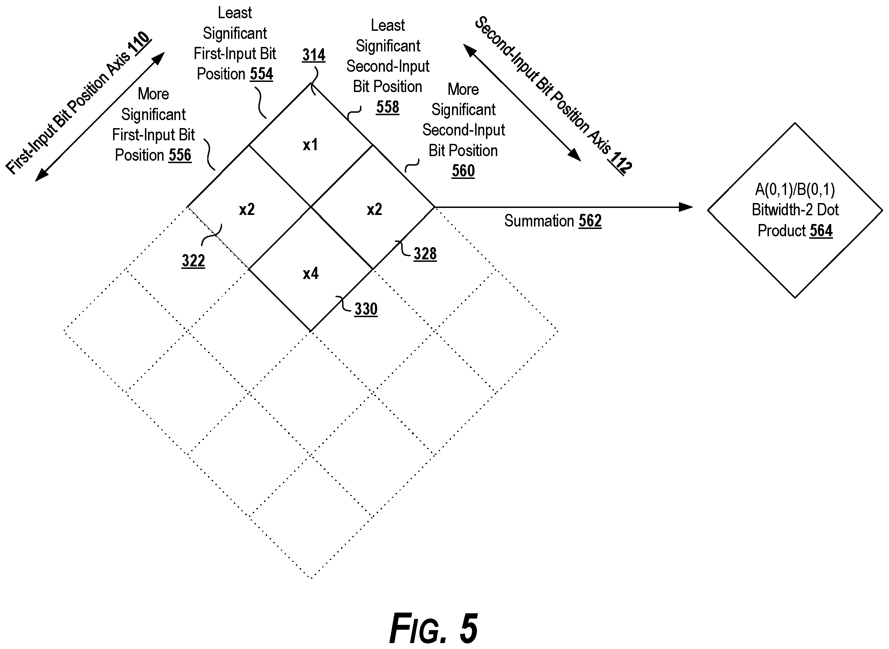

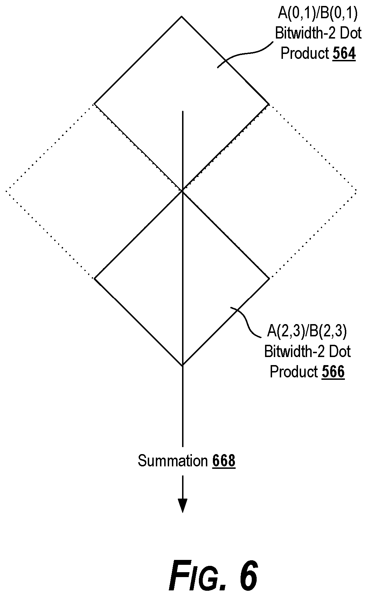

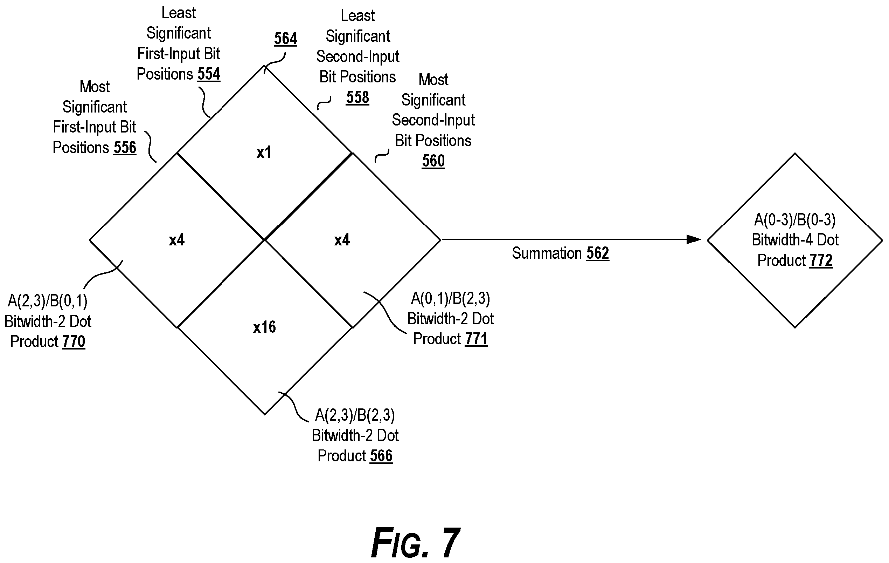

Figure 5 depicts an example operation for combining one or more dot products according to example implementations of aspects of the present disclosure. More particularly, Figure 5 depicts an example operation for combining a plurality of one-bitwidth dot products to generate one or more corresponding two-bitwidth dot products 564, which can be further combined (e.g., as described below with respect to Figures 6 and 7) to generate two-bitwidth matrix multiplication results or matrix multiplication results having bitwidths greater than two.

A plurality of dot products 314, 322, 328, and 330 can be scaled based on bit positions associated with the dot products 314, 322, 328, 330 on the first-input bit position axis 110 and second-input bit position axis 112, and a summation 562 of the scaled values can be performed to generate an $A$ (0, 1)/$B$ (0, 1) bitwidth-2 dot product 564 based on a plurality of dot products 314, 322, 328, 330, wherein each dot product of the plurality is associated with an $A$ (0) or $A$ (1) bit position and a $B$ (0) or $B$ (1) bit position.

Scaling a dot product based on the bit positions can include, for example, doubling the dot product one or more times for each bit position associated with the dot product that is not equal to a least significant bit position 554, 558. For example, if a dot product 322, 328 is associated with one bit position that is equal to a least significant bit position 554, 558 and one bit position that corresponds to a more significant bit position 556, 560 that is one greater than a corresponding least significant bit position 554, 558, then scaling the dot product 322, 328 can include doubling the dot product only once. As another example, if a dot product 330 is associated with two bit positions that each correspond to a more significant bit position 556, 560 that is one greater than a corresponding least significant bit position 554, 558, then scaling the dot product 330 can include doubling the dot product twice (e.g., quadrupling the dot product, etc.). As another example, if a dot product (e.g., dot product not depicted in Figure 5) is associated with a bit position that is greater than a corresponding least significant bit position 554, 558 by a number of bits greater than one, scaling can include doubling the dot product more than one time (e.g., quadrupling, multiplying by eight, etc.) based on the number of bits by which the bit position is greater than the corresponding least significant bit position 554, 558.

In some instances, a summation 562 can be, comprise, be comprised by, or otherwise share one or more properties with a summation 452. For example, a summation 562 can have any property described above with respect to a summation 452, except that a different group of values is being summed. In some instances, a summation 562 can be performed using computer hardware (e.g., one or more adders, etc.) that is the same as or different from hardware used to perform a summation 318 or a summation 452. In some instances, a circuit for performing a summation 562 can include a plurality of circuits for summing bits of the scaled dot products in stages (e.g., according to a Wallace tree, Dadda tree, etc.). For example, in some instances, bits of the scaled dot products can be correlated by scaled bit position, and bits of the same scaled bit position can be summed (e.g., using a plurality of adders). In some instances, bits of the sums can then be correlated once again by scaled bit position, and the scaled bit positions can be summed again (e.g., using a plurality of adders). In some instances, the process can be repeated until a final sum is determined.

Although Figure 5 depicts combining dot products associated with only two bit positions on each bit position axis 110, 112, the scaling and summation of Figure 5 can in some instances be extended to combinations involving a number of bit positions greater than two. As a non-limiting illustrative example, sixteen one-bit dot products 314, 322-350 associated with four bit positions on each bit position axis 110, 112 could be combined directly by scaling each dot product by $2^q$, wherein $q$ is a sum of: a first distance between a bit position of the dot product on the first-input bit position axis 110 and a corresponding least significant first-input bit position 554; and a second distance between a bit position of the dot product on the second-input bit position axis 112 and a corresponding least significant second-input bit position 558. As an illustrative example, an operation for combining the entire grid depicted in Figure 3B to generate a bitwidth-four dot product may include multiplying an $A$ (3)/$B$ (2) bitwise dot product 342 by $2^{((3-0)+(2-0))}$ (i.e.,

32); multiplying an *A* (1)/*B* (3) bitwise dot product 346 by $2^{((1-0)+(3-0))}$ (i.e., 16); and so on.

Additionally, although Figure 5 depicts the least significant bit positions 554, 558 equal to zero (because the depicted operation is combining dot products that include bit positions of zero on both axes), a least significant bit position 554, 558 can refer herein to a least significant bit position 554, 558 *of the dot products being combined.* Thus, if dot products being combined are *A* (2)/*B* (2), *A* (2)/*B* (3), *A* (3)/*B* (2), and *A* (3)/*B* (3) bitwise dot products 340, 342, 348, 350, then the least significant bit positions 554, 558 can each be equal to two. Additionally, a least significant first-input bit position 554 can be numerically equal to or different from a least significant second-input bit position 558. For example, if dot products being combined are *A* (0)/*B* (2), *A* (0)/*B* (3), *A* (1)/*B* (2), and *A* (1)/*B* (3) bitwise dot products, then a least significant first-input bit position can be zero, and a least significant second input bit position can be two. In some instances, a least significant bit position 554, 558 can refer to a least significant bit position relative to a bitwidth of the combined dot product. In some instances, a least significant bit position 554, 558 can include a bit position whose distance from a least significant bit position relative to a maximum supported bitwidth is an integer multiple (e.g., zero, etc.) of a bitwidth of the combined dot product being generated.

Additionally, although Figure 5 depicts combining dot products associated with the same number of bit positions on each bit position axis 110, 112, the scaling and summation of Figure 5 can in some instances be extended to combinations involving different numbers of bit positions on each axis. As a non-limiting illustrative example, a dot product of two-bit first-input values (e.g., two-bit values associated with *A* (2, 3) bit positions) and one-bit second input values (e.g., one-bit values associated with a *B* (0) bit position) can be generated by scaling and summing individual dot products (e.g., *A* (2)/*B* (0) dot product 324 and *A* (3)/*B* (0) dot product 326) based on their bit positions relative to corresponding least significant bit positions 554, 558. For example, an *A* (2)/*B* (0) dot product 324 could be scaled by a factor of one (i.e., $2^{((2-2)+(0-0))}$); an *A* (3)/*B* (0) dot product 326 could be doubled (i.e., multiplied by $2^{((3-2)+(0-0))}$); and the results could be summed to generate a corresponding *A* (2, 3)/*B* (0) dot product of two-bit first-input values and one-bit second input values. In some instances, applying different bitwidths to the first input matrix A and second input matrix B can be useful in a variety of computing applications, including but not limited to, for example, quantized machine learning. For example, in some instances, a quantized machine-learned model can include a model that may multiply one or more weight parameters (e.g., low-bitwidth weight parameters) by one or more activation values (e.g., low-bitwidth activation values). In such instances, a bitwidth associated with the weight parameters (e.g., one, two, three, four, eight, etc.) may be different from a bitwidth associated with the activation values (e.g., one, two, three, four, eight, etc.). Other applications for multiplying matrices with mismatched bitwidths are possible.

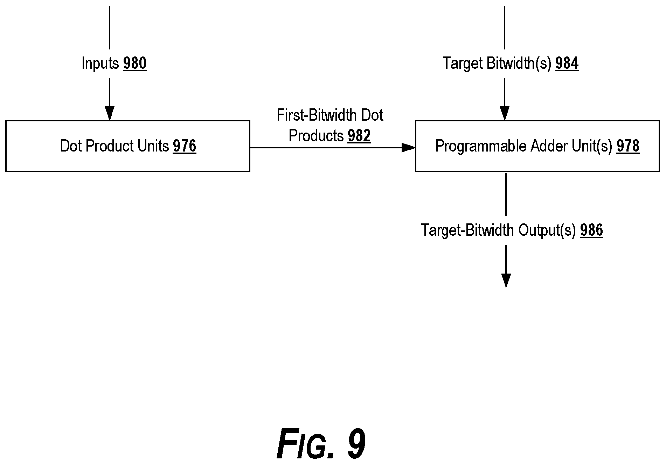

Scaling can be performed in any appropriate manner for determining a value that is equal to an appropriately scaled value. For example, in some instances, scaling a dot product by a factor of $2^q$ can include left-shifting the dot product by *q* bit positions and adding *q* trailing zeros. Similarly, summation can be performed in any appropriate manner for determining a value that is equal to a sum of values, such as using adder circuits, arithmetic logic units, or the like. In some instances, a circuit for combining dot products can include a programmable circuit for combining dot products in different ways based on one or more input values indicative of one or more target bitwidths for a matrix multiplication to be performed. As a non-limiting illustrative example, programmable adder hardware can be programmed to perform the combining depicted in Figure 4 in response to a target bitwidth of one; the combining operations depicted in Figures 5 and 6 in response to a target bitwidth of two; the combining operations depicted in Figure 5 and 7 in response to a target bitwidth of four; and so on. Additional example details of an example implementation of programmable adder hardware are further provided below with respect to Figure 9.

Additionally, although Figure 5 depicts multiplying dot products by positive numbers, scaling a dot product 314, 322-350 can in some instances include multiplying the dot product 314, 322-350 by a negative number (e.g., according to a two's complement scheme for representing signed integers, etc.). For example, in a two's complement scheme for representing numerical values, a most significant bit can represent a negative value, such as - $(2^{pos})$, where *pos* is the bit position of the most significant bit. As a non-limiting illustrative example, a four-bit two's-complement representation can treat a least significant bit (e.g., bit position zero) as a "ones" digit; a second least significant bit as a "twos" digit; a third least significant bit as a "fours" digit; and the most significant bit as a "negative eights" digit. For example, the value 1001 in such a scheme would represent -8 + 0 + 0 + 1 = -7. Continuing the non-limiting illustrative example, scaling a dot product associated with such a most significant bit could include multiplying the dot product by -8. For example, in the case of a dot product associated with a most significant bit and a least significant bit (e.g., A(3)/B(0) bitwise dot product 326, etc.), scaling the dot product could include multiplying the dot product by -8 (i.e., -8 * 1 = -8). As another example, in the case of a dot product associated with two most significant bit positions (i.e., most significant bit on a first-input bit position axis 110 *and* most significant bit on a second-input bit position axis 112), scaling the dot product could include multiplying the dot product by 64 (i.e., -8 * -8 = +64). More generally, scaling a dot product 314, 322-350 can in some instances include multiplying the dot product by (x * y), wherein x is a value (e.g., "ones" value, two, four, negative eight, etc.) associated with a first bit position of the dot product 314, 322-350 on a first-input bit position axis 110, and y is a value associated with a second bit position of the dot product 314, 322-350 on a second-input bit position axis 112. The value of each bit position can include, for example, a value of the corresponding bit position in a numerical representation applicable to the matrix multiplication being performed (e.g., numerical representation at a bitwidth of the matrix multiplication being performed, etc.).

Figure 6 depicts an example operation for combining one or more dot products according to example implementations of aspects of the present disclosure. More particularly, Figure 6 depicts an example operation for combining bitwidth-2 dot products 564, 566 to generate a two-bitwidth matrix multiplication output, wherein each input matrix *A* and *B* associated with the two-bitwidth matrix multiplication corresponds to a one-dimensional vector (i.e., one-row or one-column matrix) of bitwidth-two values. As depicted in Figure 6, a two-bitwidth matrix multiplication result can be determined by performing a summation 668 of an *A* (0, 1)/ *B* (0, 1) bidwidth-2 dot product 564 and an *A* (2, 3)/*B* (2, 3) bitwidth-2 dot product 566. This can be equivalent to performing a trace operation on a matrix of bitwidth-two dot products (e.g., matrix of bitwidth-two dot products generated according to methods described above with respect to Figure 4, etc.). This can also be equivalent, for example, to summing a plurality of bitwidth-two dot products 564,566, wherein each dot product of the sum is associated with a first-input bit position that is equal to a corresponding second-input bit position associated with the dot product.

Although Figures 5 and 6 depict determining a two-bitwidth matrix multiplication in two operations or groups of operations (i.e., determining bitwidth-two dot products, then determining a matrix multiplication result based on the dot products), a bitwidth-two matrix multiplication result can in some instances be determined in a single operation or group of operations. For example, a plurality of bitwise dot products 314, 322, 328, 330, 340, 342, 348, 350 can be scaled, and the scaled values can be summed in one summation operation or group of operations (e.g., without necessarily computing a bitwidth-two dot product 564, 566 as an intermediate result).

In some instances, a summation 668 can be, comprise, be comprised by, or otherwise share one or more properties with a summation 562. For example, a summation 668 can have any property described above with respect to a summation 562, except that a different group of values is being summed. In some instances, a summation 668 can be performed using computer hardware (e.g., one or more adders, etc.) that is the same as or different from hardware used to perform a summation 318, summation 452, or summation 562.

Figure 7 depicts an example operation for combining one or more dot products according to example implementations of aspects of the present disclosure. More particularly, Figure 7 depicts an example operation for combining a plurality of two-bitwidth dot products to generate one or more corresponding four-bitwidth dot products 772, which may correspond to one or more final four-bitwidth matrix multiplication results, or may be used in further combinations (e.g., trace operations as depicted in Figures 4 and 6, further combinations analogous to those depicted in Figures 5 and 7 to generate one or more eight-bitwidth dot products or matrix multiplication results, etc.).

A plurality of bitwidth-2 dot products 564, 566, 768, and 771 can be scaled based on bit positions associated with the dot products 564, 566, 768, and 771 on the first-input bit position axis 110 and second-input bit position axis 112, and a summation 562 of the scaled values can be performed to generate an *A* (0-3)/*B* (0-3) bitwidth-4 dot product 772 based on the plurality of dot products 564, 566, 768, and 771, wherein each dot product of the plurality is associated with an *A* (0, 1), or *A* (2, 3) bit position and a *B* (0, 1) or *B* (2, 3) bit position.

Scaling a dot product based on the bit positions can include, for example, doubling the dot product one or more times (e.g., quadrupling the dot product, etc.) for each bit position associated with the dot product that is not equal to a least significant bit position 554, 558. For example, if a dot product 770, 771 is associated with one bit position that is equal to a least significant bit position 554, 558 and one bit position that corresponds to a most significant bit position 556, 560 that is two greater than a corresponding least significant bit position 554, 558, then scaling the dot product 322, 328 can include quadrupling the dot product once. As another example, if a dot product 566 is associated with two bit positions that each correspond to a most significant bit position 556, 560 that is one greater than a corresponding least significant bit position 554, 558 by two bit positions, then scaling the dot product 330 can include quadrupling the dot product twice (e.g., multiplying the dot product by 16, etc.).

In general, a combination performed according to Figure 7 can be performed in any manner described above with respect to Figure 5, except that the two-bitwidth dot products of Figure 7 may have bit positions that differ by two, and scaling may therefore include quadrupling (e.g., to account for a two-bit-position difference) instead of doubling (e.g., to account for a one-bit-position difference). However, in other respects, any system, method, property, or other aspect described herein with respect to Figure 5 can be applied analogously to the operations depicted in Figure 7. For example, combining according to Figure 7 can include scaling each dot product by $2^q$, wherein $q$ is a sum of: a first distance between a bit position of the dot product on the first-input bit position axis 110 and a corresponding least significant first-input bit position 554; and a second distance between a bit position of the dot product on the second-input bit position axis 112 and a corresponding least significant second-input bit position 558. As another example, scaling according to Figure 7 can include left-shifting and the like. As another example, combining according to Figure 7 can include combining a number of dot products greater than or less than four, and can include combining a number of first-input bit positions that is the same as or different from a corresponding number of second-input bit positions being combined.

In some instances, variable-bitwidth matrix multiplication can include performing a plurality of combining operations, such as iteratively performing a plurality of iterative combination operations. As a non-limiting illustrative example, a processing device configured to perform variable-bitwidth matrix multiplication based on bitwidths of one, two, four, and eight could perform zero (e.g., to achieve a bitwidth of one), one (e.g., to achieve a bitwidth of two), two (e.g., to achieve a bitwidth of four), or three (e.g., to achieve a bitwidth of eight) combining iterations according to methods described herein with respect to Figures 5 or 7. Continuing the non-limiting illustrative example, the processing device can be configured to perform zero, one, or more than one combination operations according to methods described above with respect to Figures 4 and 6 based on a shape of one or more matrices associated with the matrix multiplication. More generally, in some instances, variable-bitwidth matrix multiplication for a plurality of possible bitwidths that are powers of two (e.g., $2^0 = 1$, $2^1 = 2$, $2^2 = 4$, etc.) can include, for a given target bitwidth $2^k$, where $k$ is an integer greater than zero, performing $k$ combining iterations configured to double a bitwidth of the dot products being combined (e.g., according to methods described with respect to Figures 5 and 7, etc.). Additionally, in some instances, variable-bitwidth matrix multiplication for some target bitwidths can include summing a plurality of dot products having the target bitwidth. For example, if a target bitwidth is $2^k$, and a maximum bitwidth supported by a processing device is $2^{k+j}$, where $j$ is an integer greater than zero, then a scalar matrix multiplication result can be generated by summing $2^j$ (e.g., $\frac{n}{2^k}$ ) dot products (e.g., bitwise dot products 314, 322-350; combined dot products 564, 566, 772, etc.), such as by performing a trace operation on a matrix of such dot products having a bitwidth of $2^k$.

For example, in some instances, combining one or more dot products to generate a matrix multiplication result can include: for each rth iteration of $k$ iterations, combining one or more groups of four dot product outputs having a bitwidth of $2^{r-1}$ times the first bitwidth to generate one or more dot product outputs having a bitwidth of $2^r$ times the first bitwidth; and if $2^k$ is less than $n$, summing $\frac{n}{2^k}$ dot product outputs of the one or more dot product outputs having a bitwidth of $2^k$ times the first bitwidth, wherein $n$ is a ratio of a maximum bitwidth supported by the processor device to the first bitwidth.

In some instances, a hardware device (e.g., programmable adder hardware, etc.) for performing such an iterative combination process can include a plurality of logic circuits (e.g., hard-wired logic circuits, etc.) for performing each possible operation (e.g., performing a trace operation on 1-bit results; combining 1-bit results to generate 2-bit results; performing a trace operation on 2-bit results; combining 2-bit results to generate 4-bit results; etc.) of the iterative operations, along with programmable logic for selecting between such logic circuits (e.g., routing inputs to the appropriate logic circuit; selecting between outputs; etc.). In some instances, programmable logic can include a plurality of programmable logic stages, such as a first programmable logic stage to select between operations for combining one-bit dot products; a second programmable logic stage to select between operations for combining two-bit dot products (if the one-bit dot products were combined to generate two-bit dot products); and so on.

Although Figure 7 depicts a 1 x 1 output value (scalar value) at a maximum bitwidth supported by the corresponding dot product operations (e.g., dot product operations depicted in Figures 3A, 3B, etc.), a larger number of outputs is possible without deviating from the scope of the present disclosure. For example, in some instances, a processing device may comprise a plurality of subunits each configured to perform $n^2$ dot products corresponding to an $n$ x $n$ matrix product at a first bitwidth, wherein $n$ is a ratio of a maximum bitwidth supported by the processor device to the first bitwidth (e.g., 8 bits, 32 bits, etc.). As a non-limiting illustrative example, a processing device configured to output a 4 x 4, 2 x 8, or 1 x 16 matrix multiplication result at a maximum supported bitwidth may perform 16 $n^2$ dot products corresponding to 16 $n$ x n matrix products at the first bitwidth. In some instances, such a processing device may combine each group of $n^2$ dot products in a manner described herein with respect to Figures 4 through 7 to generate 16 maximum-bitwidth output values or the like.

Figure 8 depicts an example matrix multiplication according to example implementations of aspects of the present disclosure. More particularly, Figure 8 depicts an example one-bitwidth matrix multiplication in which a matrix of bitwise dot products 320 may be used directly as a matrix multiplication result. A bitwidth-one matrix multiplication 802 can include a multiplication of an N x P bitwidth-one first input matrix **A'** and a P x N bitwidth-one second input matrix **B'** to generate an N x N matrix product 874. In some instances, P can be a positive integer corresponding to a number of entries in first and second input matrices **A** and **B** at a maximum supported bitwidth. In some instances, N can be equal to a maximum supported bitwidth supported by a processing device (e.g., if a minimum supported bitwidth is equal to one) or a ratio of a maximum supported bitwidth to minimum supported bitwidth. In some instances, a bidwidth-one first input matrix **A'** can be configured such that each row of the bidwidth-one first input matrix **A'** corresponds to a bit position of a corresponding bitwidth-N input matrix

*A* (e.g., bitwidth-8 input matrices as depicted in Figures 1A and 1B, etc.), and each column corresponds to an entry of the corresponding bitwidth-N input matrix *A*. In some instances, each of N rows of a first input matrix *A'* can be associated with $m$ bit positions of a plurality of input values of a corresponding matrix *A*, wherein $m$ can be a minimum bitwidth supported by a processing device; a bitwidth at which one or more dot products of the matrix of bitwise dot products 320 are performed; or the like. In some instances, each of N columns of a second input matrix *B'* can be associated with $m$ bit positions of a plurality of input values of a corresponding matrix *B*, wherein $m$ can be a minimum bitwidth supported by a processing device; a bitwidth at which one or more dot products of the matrix of bitwise dot products 320 are performed; or the like. In such instances, a matrix of bitwise dot products 320 can directly correspond to a valid N x N matrix product 874 and can be used directly as a matrix multiplication output (e.g., without performing any combining as depicted in Figures 4 through 7).

Although Figure 8 depicts a bitwidth-one matrix multiplication 802 associated with an N x N output, and Figures 4 and 1B depict bitwidth-one matrix multiplications associated with a 1 x 1 output (e.g., scalar output), it is also possible to combine dot products 314, 322-350 to generate other matrix multiplication outputs with other dimensions, such as N/2 x N, N/2 x N/2, 2 x 2, 4 x 4, and the like.

As an example, generating a 2 x 2 bitwidth-one matrix multiplication output based on a 4 x 4 matrix of bitwise dot products 320 can include performing four combinations of two dot products per combination based on the matrix of bitwise dot products 320. For example, if bitwidth-4 input matrices *A* and *B* in a format such that a first row of a 2 x 2Q bitwidth-one input matrices *A'* corresponds to bit positions 0 and 1 of *A;* a second row of *A'* corresponds to bit positions 2 and 3 of *A;* a first column of *B'* corresponds to bit positions 0 and 1 of *B;* and a second column of *B'* corresponds to bit positions 2 and 3 of *B;* then a 2 x 2 matrix multiplication output can be generated by summing pairs of bitwise dot products 314 and 330; 324 and 334; 336 and 346; and 340 and 350. Other input-matrix configurations are possible, and the pairs of dot products being combined can be changed to accommodate different input-matrix configurations. In general, a matrix multiplication output (e.g., N/2 x N, N/2 x N/2, 2 x 2, or 4 x 4, scalar, or other dimension of matrix multiplication output; a bitwidth-1, bitwidth-2, bitwidth-4, bitwidth-8 or other bitwidth of matrix multiplication output; etc.) can be generated by combining dot products in any manner (e.g., scaling and summing to increase a bitwidth relative to a bitwidth of dot products 314, 322-350 originally performed; summing without scaling to alter a dimension of a matrix multiplication output without changing a bitwidth; etc.) that corresponds to the desired matrix multiplication output.

Figure 9 depicts an example hardware configuration for performing matrix multiplication according to example implementations of aspects of the present disclosure. A plurality of dot product units 976 can receive inputs 980 and generate a plurality of first-bitwidth dot products 982 based on the inputs 980. One or more programmable adder units 978 can obtain a target bitwidth 984 and can generate, based on the first-bitwidth dot products 982 and target bitwidths 984, one or more target-bitwidth outputs 986.

The dot product units 976 can include, for example, any hardware devices configured to determine a dot product, partial product, summation, or other intermediate value for computing a dot product. In some instances, a dot product unit 976 can include one or more systolic arrays comprising a plurality of hardware components (e.g., cells, nodes, circuits, data processing units, logic gates such as "and" gates, adders, multipliers, etc.), with each component configured (e.g., hard-wired, etc.) to perform a portion of a dot product computation (e.g., bitwise dot product computation, first-bitwidth dot product computation, minimum-supported-bitwidth dot product computation, etc.), such as one or more individual bitwise or first-bitwidth multiplications; one or more additions; or the like. In some instances, each node of a systolic array may be configured (e.g., hard-wired, etc.) to communicate an output to one or more predetermined downstream nodes for further computation. For example, in some instances, one or more multiplication nodes (e.g., bitwise-and circuits, binary multipliers, etc.) may pass a plurality of multiplication results downstream to one or more adder nodes. As another example, in some instances, each node of an upstream layer of adder nodes may be configured (e.g., hard-wired, etc.) to pass an output to a corresponding downstream adder node. In some instances, a dot product unit 976 comprising a systolic array can include a synchronous or clocked systolic array configured to perform synchronized compute and communication cycles.

Programmable adder unit(s) 978 can include, for example, any hardware components configured to combine dot product inputs to generate variable-bitwidth matrix multiplication outputs, wherein the matrix multiplication output is based at least in part on data indicative of one or more target bitwidths. In some instances, a programmable adder unit 978 can be configured to output different-bitwidth matrix multiplication outputs responsive to one or more selection signals, such as selection signals indicative of one or more target bitwidths (e.g., target bitwidth associated with a first input matrix *A;* target bitwidth associated with a second input matrix *B;* target bitwidth associated with first and second input matrices *A* and *B;* etc.), selection signals indicative of a matrix shape or output shape (e.g., target number of rows and columns of the output; number of rows and columns of one or more input matrices; data correlating one or more higher-bitwidth input matrix *A* bit positions with one or more lower-bitwidth input matrix *A'* bit positions; etc.), selection signals indicative of a plurality of dot products to be summed, scaled, or otherwise combined; or other appropriate selection signal. For example, in some instances, a programmable adder unit 978 can include one or more hardware components (e.g., multiplexer, demultiplexer, programmable logic device such as field programmable gate array, etc.) configured to route one or more dot product outputs to one or more logic blocks of a plurality of logic blocks (e.g., adder logic blocks, logic blocks configured to scale and sum dot products according to Figures 5 and 7, etc.) based on a selection signal. As another example, in some instances, a programmable adder unit 978 can include one or more hardware components (e.g., multiplexers, programmable logic devices, etc.) configured to select between a plurality of candidate outputs (e.g., candidate outputs generated by fixed-operation or hard-wired circuits such as systolic arrays) based on a selection signal, such as a selection signal indicative of a target bitwidth. However, operating based on a selection signal is not required. For example, in some instances, a programmable adder unit 978 can include reconfigurable hardware component that may be controllable or programmable through means other than a selection signal, such as a stored configuration value obtained from a storage component (e.g., static random access memory, flash memory, electrically erasable programmable read-only memory, etc.).

In some instances, the dot product units 976 or programmable adder unit(s) 978 can include one or more devices configured to perform bit-serial arithmetic; one or more devices configured to perform bit-parallel arithmetic; or both. For example, in some instances, one or more of the dot product units 976 or programmable adder unit(s) 978 can be configured to perform bit-serial arithmetic to reduce a chip area associated with variable-bitwidth matrix multiplication (e.g., chip area of communication connections to the dot product units 976 or programmable adder unit(s) 978; chip area of dot product units 976 or programmable adder unit(s) 978 themselves; etc.). As an example, a bit-serial dot product unit 976 can include a dot product unit 976 configured to receive, for a plurality of serial communication iterations, a pair of bits (or pair of numbers at a minimum bitwidth supported by a processing device, etc.) associated with a particular pair of bit positions associated with the dot product unit (e.g., $A$ (0)/$B$ (3) bit pairs, etc.), wherein the pair of bits is associated with a pair of corresponding entries on a vector axis 108 of a pair of input matrices $A, B$. In such instances, the dot product units 976 can perform, at each iteration, a multiplication (e.g., bitwise and, etc.) of the pair of bits and a bit-serial addition operation adding the multiplication result to a running total (e.g., using a carry-save adder, etc.). Other implementations are possible.

Inputs 980 can include, for example, input matrices associated with a matrix multiplication to be performed (e.g., as depicted in one or more of Figures 1 through 8, etc.). In some instances, inputs 980 can include a first plurality of input bits corresponding to a plurality of numerical values of a first input matrix $A$ or

$A'$; and a second plurality of input bits corresponding to a second plurality of numerical values of a second input matrix $B$ or $B'$. In some instances, the inputs 980 can include bits indicative of numerical values having a bitwidth that is equal to a minimum bitwidth supported by the dot product units 976 or programmable adder units 978; a maximum bitwidth supported by the dot product units 976 or programmable adder units 978; or a bitwidth in between a minimum and maximum bitwidth. In some instances, the inputs 980 can include bits arranged as depicted in one or more of Figures 1 through 8, or in any other appropriate arrangement.

In some instances, a size (e.g., length, total number of entries, total number of input bits, etc.) of the inputs 980 can include a size configured to balance an input bandwidth and output bandwidth of a plurality of dot product units 976; a programmable adder unit 978; or other hardware (e.g., variable-bitwidth matrix multiplication device comprising the dot product units 976 and programmable adder unit(s) 978, etc.). For example, in some instances, performing operations herein (e.g., dot product operations, combining operations, etc.) at a small bitwidth can generate a greater number of output bits compared to performing the same operations at a larger bitwidth using the same number of input bits. However, this output size growth can be balanced out by increasing a length of the inputs 980. For example, increasing a length of the inputs 980 can decrease a ratio of output bits to input bits. In some instances, a size of the inputs 980 can be configured to balance an input bandwidth and output bandwidth of one or more hardware devices (e.g., dot product units 976; programmable adder unit 978; processing device comprising dot product units 976 and programmable adder unit 978; etc.) at one or more bitwidths. For example, in some instances, a ratio of total output bits to total input bits at one or more bitwidths supported by a processing device can be between 0.5 and 1.5, such as between 0.75 and 1.25; such as between 0.9 and 1.1; or the like. In other words, a number of total output bits can be between 50 and 150 percent of a number of total input bits, such as between 75 percent and 125 percent; such as between 90 percent and 110 percent; and the like. For example, in some instances, a ratio of total output bits to total input bits at a minimum bitwidth supported by the processing device; a maximum bitwidth supported by the processing device; a median bitwidth of a plurality of bitwidths supported by the processing device; or other bitwidth of interest can be between 0.5 and 1.5, such as between 0.75 and 1.25; such as between 0.9 and 1.1; or the like. In some instances, a maximum number of input bits the dot product units 976 is configured to receive can include a number configured to cause a ratio of total output bits to total input bits at one or more bitwidths to be between 0.5 and 1.5, such as between 0.75 and 1.25; such as between 0.9 and 1.1; or the like.

First-bitwidth dot products 982 can include, for example, dot products performed by the dot product units 976 at a first bitwidth. In some instances, the first bitwidth can be less than or equal to (e.g., equal to) a minimum matrix multiplication bitwidth supported by the dot product units 976 or programmable adder units 978. In some instances, the first bitwidth can be one. In some instances, the first-bitwidth dot products 982 can include dot products determined as described above with respect to one or more of Figure 2A, 2B, 3A, or 3B. For example, in some instances, a dot product 982 can include a sum of a plurality of products (e.g., bitwise products), wherein each product of the plurality of products is the product of a first subset of bits of an entry of a first input matrix *A* multiplied by a second subset of bits of a corresponding entry of a second input matrix *B.* In some instances, a bit position of each first subset on a first input bit position axis 110 can be the same as a bit position of every other first subset of a particular dot product 982. In some instances, a bit position of each second subset on a second input bit position axis 112 can be the same as a bit position of every other second subset of a particular dot product 982. In some instances, a first-subset bit position can be the same as or different from a second-subset bit position. In some instances, each first subset and each second subset can be associated with first-input-matrix and second-input-matrix entries having the same entry position on a vector axis 108.

Target bitwidth(s) 984 can include, for example, data indicative of one or more bitwidth(s) 984 at which matrix multiplication should be performed. For example, in some instances, target bitwidths can include a first target bitwidth associated with a first input matrix *A.* In some instances, target bitwidth(s) 984 can include a second target bitwidth associated with a second input matrix *B.* In some instances, target bitwidth(s) 984 can include a single target bitwidth applicable to more than one input matrix (e.g., both first input matrix *A* and second input matrix *B*).

A target-bitwidth output 986 can include, for example, a valid matrix multiplication output (e.g., scalar output, N x N or other-dimension matrix output, etc.) computed according to the target bitwidth(s) 984. In some instances, a target-bitwidth output can be computed based on first-bitwidth dot products 982 and target bitwidth(s) 984 in a manner described above with respect to one or more of Figures 1 through 8.

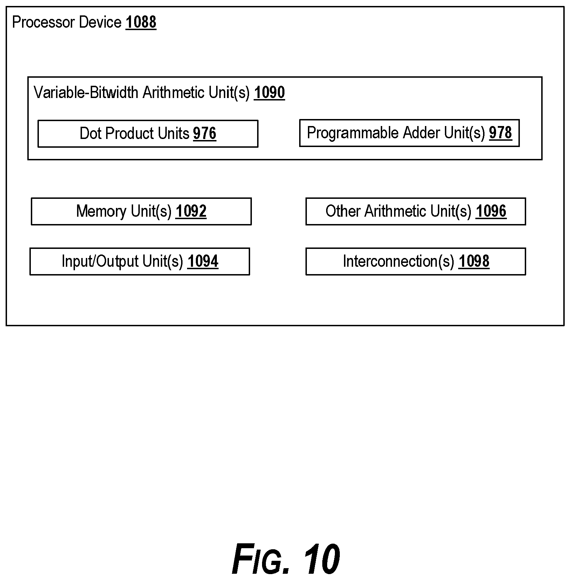

Figure 10 depicts example hardware for performing matrix multiplication according to example implementations of aspects of the present disclosure. A processor device 1088 can comprise a plurality of components, such as one or more variable-bitwidth arithmetic unit(s) 1090 comprising a plurality of dot product units 976 and one or more programmable adder units 978; one or more memory units 1092; one or more input/output units 1094; one or more other arithmetic units 1096; one or more interconnections 1098; and any other appropriate processor device component.

A processor device 1088 can include, for example, any suitable device for performing processing functions for a computing device (e.g., a processor core, a microprocessor, an ASIC, an FPGA, a controller, a microcontroller, etc.).

A variable-bitwidth arithmetic unit 1090 can include, for example, any device, component, combination of components (e.g., hardware, firmware, and software components), or the like for performing variable-bitwidth arithmetic (e.g., using dot product units 976 and programmable adder units 978; using one or more systems or methods described above with respect to one or more of Figures 1 through 8; etc.).

Memory units 1092 can include, for example, any devices configured to store (e.g., temporarily, permanently, etc.) data for use in one or more processing operations. For example, in some instances, memory 1092 units can include volatile memory devices (e.g., high-bandwidth memory, random access memory such as synchronous dynamic random access memory), registers, accumulators, or the like.

Input/output units 1094 can include, for example, any hardware components enabling a processor device 1088 to receive inputs from or provide outputs to one or more other devices. For example, in some instances, an input/output unit 1094 can include one or more connection interfaces or connection devices (e.g., peripheral component interconnect express (PCIe) interface, etc.) for connecting to one or more other processor devices; input/output devices; storage devices; or other devices of a computing system comprising a processor devices 1088.

Other arithmetic units 1096 can include, for example, any hardware components other than variable-bitwidth arithmetic units 1090 that are configured to perform one or more arithmetic operations. For example, in some instances, other arithmetic units 1096 can include arithmetic logic units, matrix multiplication units (e.g., fixed-bitwidth matrix multiplication units), floating-point arithmetic units, or other arithmetic units.

Interconnection(s) 1098 can include, for example, interconnections for communication or data transfer between components of a processor device 1088, such as connections between a variable-bitwidth arithmetic unit 1090 and other processor components 1092, 1094, 1096, etc. and interconnections for communication or data transfer within a component of the processor device (e.g., between subcomponents, etc.).

Example Methods

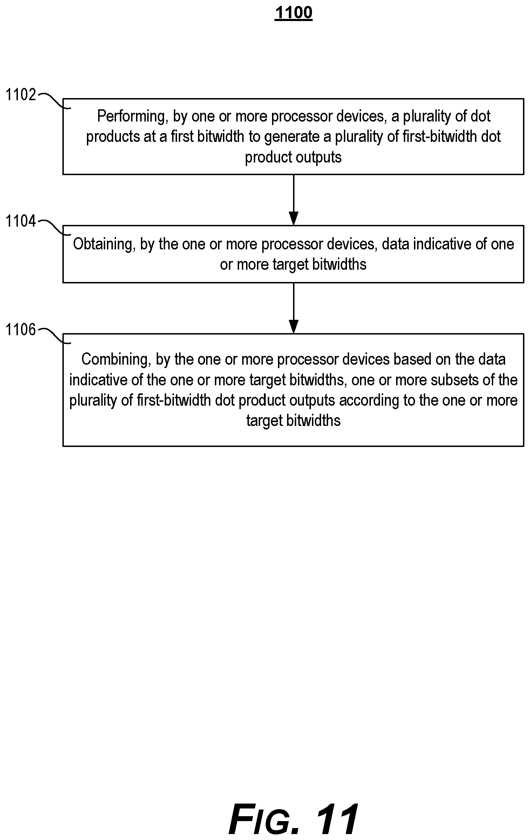

Figure 11 depicts a flowchart diagram of an example method for performing variable-bitwidth matrix multiplication according to example embodiments of the present disclosure. Although Figure 11 depicts steps performed in a particular order for purposes of illustration and discussion, the methods of the present disclosure are not limited to the particularly illustrated order or arrangement. The various steps of example method 1100 can be omitted, rearranged, combined, and/or adapted in various ways without deviating from the scope of the present disclosure.

At 1102, example method 1100 can include performing, by one or more processor devices (e.g., processor devices 1088, variable-bitwidth arithmetic units 1090, etc.), a plurality of dot products at a first bitwidth to generate a plurality of first-bitwidth dot product outputs (e.g., dot products 314, 322-350). In some instances, example method 1100 at 1102 can include using one or more systems or performing one or more activities described with respect to Figures 2A, 2B, 3A, 3B, or 9.

At 1104, example method 1100 can include obtaining, by the one or more processor devices, data (e.g., selection signal(s), etc.) indicative of one or more target bitwidths. In some instances, example method 1100 at 1104 can include using one or more systems or performing one or more activities described with respect to Figures 4-9.

At 1106, example method 1100 can include combining, by the one or more processor devices based on the data indicative of the one or more target bitwidths, one or more subsets of the plurality of first-bitwidth dot product outputs according to the one or more target bitwidths. In some instances, example method 1100 at 1106 can include using one or more systems or performing one or more activities described with respect to Figures 4-9.

Example Computing Systems and Devices

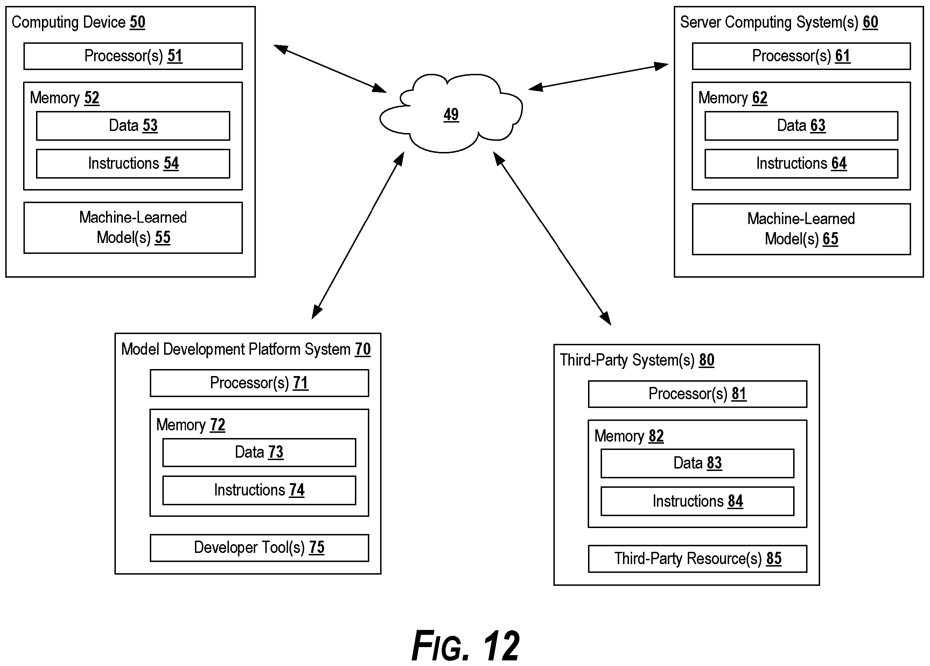

Figure 12 is a block diagram of an example networked computing system that can perform aspects of example implementations of the present disclosure. The system can include a number of computing devices and systems that are communicatively coupled over a network 49. An example computing device 50 is described to provide an example of a computing device that can perform any aspect of the present disclosure (e.g., implementing model host 31, client(s) 32, or both). An example server computing system 60 is described as an example of a server computing system that can perform any aspect of the present disclosure (e.g., implementing model host 31, client(s) 32, or both). Computing device 50 and server computing system(s) 60 can cooperatively interact (e.g., over network 49) to perform any aspect of the present disclosure (e.g., implementing model host 31, client(s) 32, or both). Model development platform system 70 is an example system that can host or serve model development platform(s) 12 for development of machine-learned models. Third-party system(s) 80 are example system(s) with which any of computing device 50, server computing system(s) 60, or model development platform system(s) 70 can interact in the performance of various aspects of the present disclosure (e.g., engaging third-party tools, accessing third-party databases or other resources, etc.).

Network 49 can be any type of communications network, such as a local area network (e.g., intranet), wide area network (e.g., Internet), or some combination thereof and can include any number of wired or wireless links. In general, communication over network 49 can be carried via any type of wired or wireless connection, using a wide variety of communication protocols (e.g., TCP/IP, HTTP, SMTP, FTP), encodings or formats (e.g., HTML, XML), or protection schemes (e.g., VPN, secure HTTP, SSL). Network 49 can also be implemented via a system bus. For instance, one or more devices or systems of Figure 12 can be co-located with, contained by, or otherwise integrated into one or more other devices or systems.

Computing device 50 can be any type of computing device, such as, for example, a personal computing device (e.g., laptop or desktop), a mobile computing device (e.g., smartphone or tablet), a gaming console or controller, a wearable computing device, an embedded computing device, a server computing device, a virtual machine operating on a host device, or any other type of computing device. Computing device 50 can be a client computing device. Computing device 50 can be an end-user computing device. Computing device 50 can be a computing device of a service provided that provides a service to an end user (who may use another computing device to interact with computing device 50).

Computing device 50 can include one or more processors 51 and a memory 52. Processor(s) 51 can be any suitable processing device (e.g., a processor core, a microprocessor, an ASIC, an FPGA, a controller, a microcontroller, etc.) and can be one processor or a plurality of processors that are operatively connected. Memory 52 can include one or more non-transitory computer-readable storage media, such as HBM, RAM, ROM, EEPROM, EPROM, flash memory devices, magnetic disks, etc., and combinations thereof. Memory 52 can store data 53 and instructions 54 which can be executed by processor(s) 51 to cause computing device 50 to perform operations. The operations can implement any one or multiple features described herein. The operations can implement example methods and techniques described herein.

Computing device 50 can also include one or more input components that receive user input. For example, a user input component can be a touch-sensitive component (e.g., a touch-sensitive display screen or a touch pad) that is sensitive to the touch of a user input object (e.g., a finger or a stylus). The touch-sensitive component can serve to implement a virtual keyboard. Other example user input components include a microphone, camera, LIDAR, a physical keyboard or other buttons, or other means by which a user can provide user input.

Computing device 50 can store or include one or more machine-learned models 55. Machine-learned models 55 can include one or more machine-learned model(s) 1, such as a sequence processing model 4. Machine-learned models 55 can include one or multiple model instance(s) 31-1. Machine-learned model(s) 55 can be received from server computing system(s) 60, model development platform system 70, third party system(s) 80 (e.g., an application distribution platform), or developed locally on computing device 50. Machine-learned model(s) 55 can be loaded into memory 52 and used or otherwise implemented by processor(s) 51. Computing device 50 can implement multiple parallel instances of machine-learned model(s) 55.

Server computing system(s) 60 can include one or more processors 61 and a memory 62. Processor(s) 61 can be any suitable processing device (e.g., a processor core, a microprocessor, an ASIC, an FPGA, a controller, a microcontroller, etc.) and can be one processor or a plurality of processors that are operatively connected. Memory 62 can include one or more non-transitory computer-readable storage media, such as HBM, RAM, ROM, EEPROM, EPROM, flash memory devices, magnetic disks, etc., and combinations thereof. Memory 62 can store data 63 and instructions 64 which can be executed by processor(s) 61 to cause server computing system(s) 60 to perform operations. The operations can implement any one or multiple features described herein. The operations can implement example methods and techniques described herein.

In some implementations, server computing system 60 includes or is otherwise implemented by one or multiple server computing devices. In instances in which server computing system 60 includes multiple server computing devices, such server computing devices can operate according to sequential computing architectures, parallel computing architectures, or some combination thereof.

Server computing system 60 can store or otherwise include one or more machine-learned models 65. Machine-learned model(s) 65 can be the same as or different from machine-learned model(s) 55. Machine-learned models 65 can include one or more machine-learned model(s) 1, such as a sequence processing model 4. Machine-learned models 65 can include one or multiple model instance(s) 31-1. Machine-learned model(s) 65 can be received from computing device 50, model development platform system 70, third party system(s) 80, or developed locally on server computing system(s) 60. Machine-learned model(s) 65 can be loaded into memory 62 and used or otherwise implemented by processor(s) 61. Server computing system(s) 60 can implement multiple parallel instances of machine-learned model(s) 65.

In an example configuration, machine-learned models 65 can be included in or otherwise stored and implemented by server computing system 60 to establish a client-server relationship with computing device 50 for serving model inferences. For instance, server computing system(s) 60 can implement model host 31 on behalf of client(s) 32 on computing device 50. For instance, machine-learned models 65 can be implemented by server computing system 60 as a portion of a web service (e.g., remote machine-learned model hosting service, such as an online interface for performing machine-learned model operations over a network on server computing system(s) 60). For instance, server computing system(s) 60 can communicate with computing device 50 over a local intranet or internet connection. For instance, computing device 50 can be a workstation or endpoint in communication with server computing system(s) 60, with implementation of machine-learned models 65 being managed by server computing system(s) 60 to remotely perform inference (e.g., for runtime or training operations), with output(s) returned (e.g., cast, streamed, etc.) to computing device 50. Machine-learned models 65 can work cooperatively or interoperatively with machine-learned models 55 on computing device 50 to perform various tasks.

Model development platform system(s) 70 can include one or more processors 71 and a memory 72. Processor(s) 71 can be any suitable processing device (e.g., a processor core, a microprocessor, an ASIC, an FPGA, a controller, a microcontroller, etc.) and can be one processor or a plurality of processors that are operatively connected. Memory 72 can include one or more non-transitory computer-readable storage media, such as HBM, RAM, ROM, EEPROM, EPROM, flash memory devices, magnetic disks, etc., and combinations thereof. Memory 72 can store data 73 and instructions 74 which can be executed by processor(s) 71 to cause model development platform system(s) 70 to perform operations. The operations can implement any one or multiple features described herein. The operations can implement example methods and techniques described herein. Example operations include the functionality described herein with respect to model development platform 12. This and other functionality can be implemented by developer tool(s) 75.

Third-party system(s) 80 can include one or more processors 81 and a memory 82. Processor(s) 81 can be any suitable processing device (e.g., a processor core, a microprocessor, an ASIC, an FPGA, a controller, a microcontroller, etc.) and can be one processor or a plurality of processors that are operatively connected. Memory 82 can include one or more non-transitory computer-readable storage media, such as HBM, RAM, ROM, EEPROM, EPROM, flash memory devices, magnetic disks, etc., and combinations thereof. Memory 82 can store data 83 and instructions 84 which can be executed by processor(s) 81 to cause third-party system(s) 80 to perform operations. The operations can implement any one or multiple features described herein. The operations can implement example methods and techniques described herein. Example operations include the functionality described herein with respect to tools and other external resources called when training or performing inference with machine-learned model(s) 1, 4, 16, 20, 55, 65, etc. (e.g., third-party resource(s) 85).

Figure 12 illustrates one example arrangement of computing systems that can be used to implement the present disclosure. Other computing system configurations can be used as well. For example, in some implementations, one or both of computing system 50 or server computing system(s) 60 can implement all or a portion of the operations of model development platform system 70. For example, computing system 50 or server computing system(s) 60 can implement developer tool(s) 75 (or extensions thereof) to develop, update/train, or refine machine-learned models 1, 4, 16, 20, 55, 65, etc. using one or more techniques described herein with respect to model alignment toolkit 17. In this manner, for instance, computing system 50 or server computing system(s) 60 can develop, update/train, or refine machine-learned models based on local datasets (e.g., for model personalization/customization, as permitted by user data preference selections).

Additional Disclosure

The technology discussed herein makes reference to servers, databases, software applications, and other computer-based systems, as well as actions taken and information sent to and from such systems. The inherent flexibility of computer-based systems allows for a great variety of possible configurations, combinations, and divisions of tasks and functionality between and among components. For instance, processes discussed herein can be implemented using a single device or component or multiple devices or components working in combination. Databases and applications can be implemented on a single system or distributed across multiple systems. Distributed components can operate sequentially or in parallel.

While the present subject matter has been described in detail with respect to various specific example embodiments thereof, each example is provided by way of explanation, not limitation of the disclosure. Those skilled in the art, upon attaining an understanding of the foregoing, can readily produce alterations to, variations of, and equivalents to such embodiments. Accordingly, the subject disclosure does not preclude inclusion of such modifications, variations or additions to the present subject matter as would be readily apparent to one of ordinary skill in the art. For instance, features illustrated or described as part of one embodiment can be used with another embodiment to yield a still further embodiment. Thus, it is intended that the present disclosure cover such alterations, variations, and equivalents.

Aspects of the disclosure have been described in terms of illustrative embodiments thereof. Any and all features in the following claims can be combined or rearranged in any way possible, including combinations of claims not explicitly enumerated in combination together, as the example claim dependencies listed herein should not be read as limiting the scope of possible combinations of features disclosed herein. Accordingly, the scope of the present disclosure is by way of example rather than by way of limitation, and the subject disclosure does not preclude inclusion of such modifications, variations or additions to the present subject matter as would be readily apparent to one of ordinary skill in the art. Moreover, terms are described herein using lists of example elements joined by conjunctions such as "and," "or," "but," etc. It should be understood that such conjunctions are provided for explanatory purposes only. Clauses and other sequences of items joined by a particular conjunction such as "or," for example, can refer to "and/or," "at least one of", "any combination of" example elements listed therein, etc. Terms such as "based on" should be understood as "based at least in part on."

The term "can" should be understood as referring to a possibility of a feature in various implementations and not as prescribing an ability that is necessarily present in every implementation. For example, the phrase "X can perform Y" should be understood as indicating that, in various implementations, X has the potential to be configured to perform Y, and not as indicating that in every instance X must always be able to perform Y. It should be understood that, in various implementations, X might be unable to perform Y and remain within the scope of the present disclosure.

The term "may" should be understood as referring to a possibility of a feature in various implementations and not as prescribing an ability that is necessarily present in every implementation. For example, the phrase "X may perform Y" should be understood as indicating that, in various implementations, X has the potential to be configured to perform Y, and not as indicating that in every instance X must always be able to perform Y. It should be understood that, in various implementations, X might be unable to perform Y and remain within the scope of the present disclosure.

This specification also includes the following clauses:

Clause 1: A processor device for performing variable-bitwidth matrix multiplication, comprising: dot product hardware configured to perform a plurality of dot products at a first bitwidth to generate a plurality of first-bitwidth dot product outputs; and programmable adder hardware configured to: obtain data indicative of one or more target bitwidths; and combine, based on the data indicative of the one or more target bitwidths, one or more subsets of the plurality of first-bitwidth dot product outputs according to the one or more target bitwidths.

Clause 2. The processor device of clause 1, wherein the first bitwidth is one bit.

Clause 3. The processor device of clause 1, wherein the one or more target bitwidths comprise at least one of: a first target bitwidth applicable to a first input matrix associated with the plurality of dot products and a second target bitwidth applicable to a second input matrix associated with the plurality of dot products; or a single target bitwidth applicable to both of a first and second input matrix associated with the plurality of dot products.

Clause 4. The processor device of clause 1, wherein: the plurality of dot products comprises n2 dot products, wherein n is a ratio of a maximum bitwidth supported by the processor device to the first bitwidth; and the plurality of first-bitwidth dot product outputs comprises n2 outputs corresponding to an n × n matrix product of an n × p first input matrix and a p × n second input matrix, wherein p is a positive integer.

Clause 5. The processor device of clause 4, wherein each of n rows of the n × p first input matrix is associated with m bit positions of a first plurality of p input values, wherein m is the first bitwidth and each of the p input values has a bitwidth equal to the maximum bitwidth supported by the processor device; and wherein each of n columns of the p × n second input matrix is associated with m bit positions of a second plurality of p input values having a bitwidth equal to the maximum bitwidth supported by the processor device.

Clause 6. The processor device of clause 4, wherein combining the plurality of first-bitwidth dot product outputs according to the one or more target bitwidths comprises: if each of the one or more target bitwidths is equal to the first bitwidth, summing n first-bitwidth dot product outputs of the plurality of first-bitwidth dot product outputs to generate a scalar first-bitwidth matrix multiplication output.

Clause 7. The processor device of clause 6, wherein summing the n first-bitwidth dot product outputs comprises performing a trace operation on the n × n matrix product.

Clause 8. The processor device of clause 1, wherein combining the plurality of first-bitwidth dot product outputs according to the target bitwidth comprises: if at least one target bitwidth of the one or more target bitwidths is greater than the first bitwidth, combining one or more groups of first-bitwidth dot product outputs to generate one or more second-bitwidth dot product outputs corresponding to a second bitwidth that is greater than the first bitwidth.

Clause 9. The processor device of clause 8, wherein combining the one or more groups of first-bitwidth dot products comprises: scaling each respective first-bitwidth dot product output of the group of dot products by a factor of 2q, wherein q corresponds to a sum of one or more distances between one or more bit positions associated with the respective first-bitwidth dot product output and one or more corresponding least significant bit positions; and summing the scaled first-bitwidth dot product outputs.

Clause 10. The processor device of clause 8, wherein combining the one or more groups of first-bitwidth dot products comprises: if each of the of the one or more target bitwidths is equal to 2k times the first bitwidth, wherein k is an integer greater than or equal to zero, and if the maximum bitwidth supported by the processing device is equal to 2k+j times the first bitwidth, wherein j is an integer greater than or equal to zero: for each rth iteration of k iterations, combining one or more groups of four dot product outputs having a bitwidth of 2r-1 times the first bitwidth to generate one or more dot product outputs having a bitwidth of 2r times the first bitwidth; and if 2k is less than n, summing n/2^k dot product outputs of the one or more dot product outputs having a bitwidth of 2k times the first bitwidth, wherein n is a ratio of a maximum bitwidth supported by the processor device to the first bitwidth.

Clause 11. The processor device of clause 10, wherein summing the n/2^k dot products comprises performing a trace operation on an n/2^k × n/2^k matrix comprising the dot product outputs having the bitwidth of 2k times the first bitwidth.

Clause 12. The processor device of clause 1, wherein the combining comprises two's-complement arithmetic.

Clause 13. The processor device of clause 1, wherein the dot product hardware comprises one or more systolic arrays for performing one or more first-bitwidth dot products.

Clause 14. The processor device of clause 1, wherein at least one of the dot product hardware and programmable adder hardware is configured to perform bit-serial arithmetic.

Clause 15. The processor device of clause 1, wherein a number of total output bits associated with the plurality of dot products is between 75 percent and 125 percent of a number of total input bits associated with the plurality of dot products.

Clause 16. A method, comprising: performing, by one or more processor devices, a plurality of dot products at a first bitwidth to generate a plurality of first-bitwidth dot product outputs; obtaining, by the one or more processor devices, data indicative of one or more target bitwidths; and combining, by the one or more processor devices based on the data indicative of the one or more target bitwidths, one or more subsets of the plurality of first-bitwidth dot product outputs according to the one or more target bitwidths.

Clause 17. The method of clause 16, wherein combining the one or more subsets comprises at least one of: if each of the one or more target bitwidths is equal to the first bitwidth, summing n first-bitwidth dot product outputs of the plurality of first-bitwidth dot product outputs to generate a combined first-bitwidth dot product output, wherein n is a ratio of a maximum bitwidth supported by the processor device to the first bitwidth; and if at least one target bitwidth of the one or more target bitwidths is greater than the first bitwidth, combining one or more groups of first-bitwidth dot product outputs to generate one or more second-bitwidth dot product outputs corresponding to a second bitwidth that is greater than the first bitwidth.

Clause 18. The method of clause 16, wherein: the plurality of dot products comprises n2 dot products, wherein n is a ratio of a maximum bitwidth supported by the processor device to the first bitwidth; and the plurality of first-bitwidth dot product outputs comprises n2 outputs corresponding to an n × n matrix product of a p × n first input matrix and an n × p second input matrix.

Clause 19. A computing system, comprising: one or more processor devices for performing variable-bitwidth matrix multiplication, the one or more processor devices comprising: dot product hardware configured to perform a plurality of dot products at a first bitwidth to generate a plurality of first-bitwidth dot product outputs; and programmable adder hardware configured to: obtain data indicative of one or more target bitwidths; and combine, based on the data indicative of the one or more target bitwidths, one or more subsets of the plurality of first-bitwidth dot product outputs according to the one or more target bitwidths.

Clause 20. The computing system of clause 19, wherein combining the one or more subsets comprises at least one of: if each of the one or more target bitwidths is equal to the first bitwidth, summing n first-bitwidth dot product outputs of the plurality of first-bitwidth dot product outputs to generate a combined first-bitwidth dot product output wherein n is a ratio of a maximum bitwidth supported by the processor device to the first bitwidth; and if at least one target bitwidth of the one or more target bitwidths is greater than the first bitwidth, combining one or more groups of first-bitwidth dot product outputs to generate one or more second-bitwidth dot product outputs corresponding to a second bitwidth that is greater than the first bitwidth.

**Claims**

1. A processor device for performing variable-bitwidth matrix multiplication, comprising:

    dot product hardware configured to perform a plurality of dot products at a first bitwidth to generate a plurality of first-bitwidth dot product outputs; and
    programmable adder hardware configured to:

        obtain data indicative of one or more target bitwidths; and
        combine, based on the data indicative of the one or more target bitwidths, one or more subsets of the plurality of first-bitwidth dot product outputs according to the one or more target bitwidths.

2. The processor device of claim 1, wherein the first bitwidth is one bit.

3. The processor device of claim 1 or claim 2, wherein the one or more target bitwidths comprise at least one of:

    a first target bitwidth applicable to a first input matrix associated with the plurality of dot products and a second target bitwidth applicable to a second input matrix associated with the plurality of dot products; or
    a single target bitwidth applicable to both of a first and second input matrix associated with the plurality of dot products.

4. The processor device of any preceding claim, wherein:

    the plurality of dot products comprises $n^2$ dot products, wherein $n$ is a ratio of a maximum bitwidth supported by the processor device to the first bitwidth; and
    the plurality of first-bitwidth dot product outputs comprises $n^2$ outputs corresponding to an $n \times n$ matrix product of an $n \times p$ first input matrix and a $p \times n$ second input matrix, wherein $p$ is a positive integer.

5. The processor device of claim 4, wherein each of $n$ rows of the $n \times p$ first input matrix is associated with $m$ bit positions of a first plurality of $p$ input values, wherein $m$ is the first bitwidth and each of the $p$ input values has a bitwidth equal to the maximum bitwidth supported by the processor device; and wherein each of $n$ columns of the $p \times n$ second input matrix is associated with $m$ bit positions of a second plurality of $p$ input values having a bitwidth equal to the maximum bitwidth supported by the processor device.

6. The processor device of claim 4 or claim 5, wherein combining the plurality of first-bitwidth dot product outputs according to the one or more target bitwidths comprises:
   if each of the one or more target bitwidths is equal to the first bitwidth, summing $n$ first-bitwidth dot product outputs of the plurality of first-bitwidth dot product outputs to generate a scalar first-bitwidth matrix multiplication output, optionally, wherein summing the $n$ first-bitwidth dot product outputs comprises performing a trace operation on the n × n matrix product.

7. The processor device of any preceding claim, wherein combining the plurality of first-bitwidth dot product outputs according to the target bitwidth comprises:
   if at least one target bitwidth of the one or more target bitwidths is greater than the first bitwidth, combining one or more groups of first-bitwidth dot product outputs to generate one or more second-bitwidth dot product outputs corresponding to a second bitwidth that is greater than the first bitwidth.

8. The processor device of claim 7, wherein combining the one or more groups of first-bitwidth dot products comprises:

scaling each respective first-bitwidth dot product output of the group of dot products by a factor of $2^q$, wherein $q$ corresponds to a sum of one or more distances between one or more bit positions associated with the respective first-bitwidth dot product output and one or more corresponding least significant bit positions; and summing the scaled first-bitwidth dot product outputs.

9. The processor device of claim 7, wherein combining the one or more groups of first-bitwidth dot products comprises:

if each of the of the one or more target bitwidths is equal to $2^k$ times the first bitwidth, wherein $k$ is an integer greater than or equal to zero, and if the maximum bitwidth supported by the processing device is equal to $2^{k+j}$ times the first bitwidth, wherein $j$ is an integer greater than or equal to zero:

for each rth iteration of $k$ iterations, combining one or more groups of four dot product outputs having a bitwidth of $2^{r-1}$ times the first bitwidth to generate one or more dot product outputs having a bitwidth of $2^r$ times the first bitwidth; and

if $2^k$ is less than $n$, summing $\frac{n}{2^k}$ dot product outputs of the one or more dot product outputs having a bitwidth of $2^k$ times the first bitwidth, wherein $n$ is a ratio of a maximum bitwidth supported by the processor device to the first bitwidth, optionally wherein summing the $\frac{n}{2^k}$ dot products comprises performing a trace operation on an $\frac{n}{2^k} \times \frac{n}{2^k}$ matrix comprising the dot product outputs having the bitwidth of $2^k$ times the first bitwidth.

10. The processor device of any preceding claim, wherein the combining comprises two's-complement arithmetic.

11. The processor device of any preceding claim, wherein the dot product hardware comprises one or more systolic arrays for performing one or more first-bitwidth dot products, and/or wherein at least one of the dot product hardware and programmable adder hardware is configured to perform bit-serial arithmetic, and/or wherein a number of total output bits associated with the plurality of dot products is between 75 percent and 125 percent of a number of total input bits associated with the plurality of dot products.

12. A method, comprising:

performing, by one or more processor devices, a plurality of dot products at a first bitwidth to generate a plurality of first-bitwidth dot product outputs;
obtaining, by the one or more processor devices, data indicative of one or more target bitwidths; and
combining, by the one or more processor devices based on the data indicative of the one or more target bitwidths, one or more subsets of the plurality of first-bitwidth dot product outputs according to the one or more target bitwidths.

13. The method of claim 12, wherein combining the one or more subsets comprises at least one of:

if each of the one or more target bitwidths is equal to the first bitwidth, summing n first-bitwidth dot product outputs of the plurality of first-bitwidth dot product outputs to generate a combined first-bitwidth dot product output, wherein n is a ratio of a maximum bitwidth supported by the processor device to the first bitwidth; and
if at least one target bitwidth of the one or more target bitwidths is greater than the first bitwidth, combining one or more groups of first-bitwidth dot product outputs to generate one or more second-bitwidth dot product outputs corresponding to a second bitwidth that is greater than the first bitwidth.

14. The method of claim 12 or 13, wherein:

the plurality of dot products comprises $n^2$ dot products, wherein $n$ is a ratio of a maximum bitwidth supported by the processor device to the first bitwidth; and
the plurality of first-bitwidth dot product outputs comprises $n^2$ outputs corresponding to an $n \times n$ matrix product of a $p \times n$ first input matrix and an $n \times p$ second input matrix.

15. A computing system, comprising:
one or more processor devices for performing variable-bitwidth matrix multiplication, the one or more processor devices comprising:

dot product hardware configured to perform a plurality of dot products at a first bitwidth to generate a plurality of first-bitwidth dot product outputs; and

programmable adder hardware configured to perform a method according to any of claims 12 to 14.

**Bitwidth-8 Matrix Multiplication 102a**

Vector Axis 108

$$[57, 83, 12, 8] * [87$$
$$A_1 \quad A_2 \quad A_3 \quad A_4$$

$A$

$B_1$

$35$ — $B_2$

$21$ — $B_3$

$18]$ — $B_4$

Vector Axis 108

$B$

**Individual Bitwidth-8 Multiplications 104a**

$$57 * 87 + 83 * 35 + \ldots + 8 * 18$$

**Binary Representation 106**

$$A_1(7) \quad A_1(5) \quad A_1(3) \quad A_1(1)$$

$$00111001 \quad * \quad 01010111$$

$$A_1(6) \quad A_1(4) \quad A_1(2) \quad A_1(0)$$

First-Input Bit Position Axis 110

$$B_1(7) \quad B_1(5) \quad B_1(3) \quad B_1(1)$$

$$B_1(6) \quad B_1(4) \quad B_1(2) \quad B_1(0)$$

Second-Input Bit Position Axis 112

*FIG. 1A*

Bitwidth-1 Matrix Multiplication 102b

$$[A_1(7),\ A_1(6),\ A_1(5),\ A_1(4),\ A_1(3),\ \ldots] * \begin{bmatrix} B_1(7) \\ B_1(6) \\ B_1(5) \\ B_1(4) \\ B_1(3) \\ \vdots \end{bmatrix}$$

$$[0,\ 0,\ 1,\ 1,\ \ldots] * \begin{bmatrix} 0 \\ 1 \\ 0 \\ 1 \\ 0 \\ \vdots \end{bmatrix}$$

Individual Bitwidth-1 Multiplications 104b

$$A_1(7) \cdot B_1(7) + A_1(6) \cdot B_1(6) + A_1(5) \cdot B_1(5) + A_1(4) \cdot B_1(4) + \ldots$$

$$0 * 0 + 0 * 1 + 1 * 0 + 1 * 1 + \ldots$$

*FIG. 1B*

First-Input Bit Position Axis **110**

Second-Input Bit Position Axis **112**

$A_1(0) * B_1(0)$

$A_1(1) * B_1(0)$

$A_1(0) * B_1(1)$

$A_1(2) * B_1(0)$

$A_1(1) * B_1(1)$

$A_1(0) * B_1(2)$

$A_1(3) * B_1(0)$

$A_1(2) * B_1(1)$

$A_1(1) * B_1(2)$

$A_1(0) * B_1(3)$

$A_1(3) * B_1(1)$

$A_1(2) * B_1(2)$

$A_1(1) * B_1(3)$

$A_1(3) * B_1(3)$

$A_1(2) * B_1(3)$

$A_1(3) * B_1(3)$

*FIG. 2A*

*FIG. 2B*

*FIG. 3A*

Matrix of Bitwise Dot Products 320

First Bitwise Dot Product 314

A(0)/B(1) Bitwise Dot Product 328

A(0)/B(2) Bitwise Dot Product 336

A(0)/B(3) Bitwise Dot Product 344

A(1)/B(0) Bitwise Dot Product 322

A(1)/B(1) Bitwise Dot Product 330

A(1)/B(2) Bitwise Dot Product 338

A(1)/B(3) Bitwise Dot Product 346

A(2)/B(0) Bitwise Dot Product 324

A(2)/B(1) Bitwise Dot Product 332

A(2)/B(2) Bitwise Dot Product 340

A(2)/B(3) Bitwise Dot Product 348

A(3)/B(0) Bitwise Dot Product 326

A(3)/B(1) Bitwise Dot Product 334

A(3)/B(2) Bitwise Dot Product 342

A(3)/B(3) Bitwise Dot Product 350

*FIG. 3B*

**FIG. 4**

*FIG. 5*

EP 4 687 025 A1

A(0,1)/B(0,1)
Bitwidth-2 Dot
Product **564**

A(2,3)/B(2,3)
Bitwidth-2 Dot
Product **566**

Summation **668**

*FIG. 6*

*FIG. 7*

EP 4 687 025 A1

Bitwidth-1 Matrix Multiplication **802**

$A_1(0)$  $A_2(0)$  $A_3(0)$  $A_4(0)$  $A_5(0)$ $\quad$ $B_1(0)$ $B_1(1)$ $B_1(3)$ $B_1(N)$

$$[0, \quad 0, \quad 1, \quad 1, \quad 1, \ldots \quad * \quad [0, 1, 1, 0, \ldots 1$$

$A_1(1)$ $1, \quad 1, \quad 0, \quad 0, \quad 1, \ldots \quad B_2(0)$ $1, 0, 0, 1, \ldots$

$A_1(2)$ $0, \quad 1, \quad 1, \quad 1, \quad 0, \ldots \quad B_3(0)$ $1, 1, 1, 0, \ldots$

$\ldots \qquad \ldots ]$

$A_1(N)$ $0, \quad 1, \quad 1, \quad 1, \quad 0, \ldots$

Matrix of Bitwise
Dot Products **320**

N x N Matrix
Product **874**

## FIG. 8

Inputs **980**

Target Bitwidth(s) **984**

| Dot Product Units **976** | First-Bitwidth Dot Products **982** | Programmable Adder Unit(s) **978** |

Target-Bitwidth Output(s) **986**

*FIG. 9*

Processor Device **1088**

Variable-Bitwidth Arithmetic Unit(s) **1090**

Dot Product Units **976**

Programmable Adder Unit(s) **978**

Memory Unit(s) **1092**

Other Arithmetic Unit(s) **1096**

Input/Output Unit(s) **1094**

Interconnection(s) **1098**

*FIG. 10*

**1100**

1102 — Performing, by one or more processor devices, a plurality of dot products at a first bitwidth to generate a plurality of first-bitwidth dot product outputs

1104 — Obtaining, by the one or more processor devices, data indicative of one or more target bitwidths

1106 — Combining, by the one or more processor devices based on the data indicative of the one or more target bitwidths, one or more subsets of the plurality of first-bitwidth dot product outputs according to the one or more target bitwidths

## FIG. 11

*FIG. 12*

| | Europäisches Patentamt<br>European Patent Office<br>Office européen des brevets | **EUROPEAN SEARCH REPORT** | **Application Number**<br>EP 25 19 2929 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | UMUROGLU YAMAN YAMANU@XILINX COM ET AL: "Optimizing Bit-Serial Matrix Multiplication for Reconfigurable Computing", ACM TRANSACTIONS ON RECONFIGURABLE TECHNOLOGY AND SYSTEMS, ACM, US, vol. 12, no. 3, 20 August 2019 (2019-08-20), pages 1-24, XP058692148, ISSN: 1936-7406, DOI: 10.1145/3337929 * sections 2.1, 2.2, 3.3; figures 1,3 * * algorithm 1 * | 1-15 | INV.<br>G06F7/544<br>G06F17/00<br>G06F9/30<br>G06F17/16<br>G06F9/00<br>G06F5/00<br><br>ADD.<br>G06F7/76<br>H03M7/04 |
| X | US 2023/359694 A1 (KHAN HAMZA [US] ET AL) 9 November 2023 (2023-11-09) | 1,12,15 | |
| A | * paragraph [0005] * * paragraph [0046] * * paragraph [0052] * * paragraph [0109] * * figures 10A, 10B * | 2-11,13, 14 | |
| A | EP 3 674 986 A1 (SAMSUNG ELECTRONICS CO LTD [KR]) 1 July 2020 (2020-07-01) * paragraph [0009] * * paragraph [0011] - paragraph [0012] * * paragraph [0014] * * paragraph [0017] * * paragraph [0048] - paragraph [0049] * * paragraph [0052] - paragraph [0053] * * paragraph [0074] * * equation 3; figure 4 * | 1-15 | TECHNICAL FIELDS SEARCHED (IPC)<br><br>G06F<br>H03M |

The present search report has been drawn up for all claims

| Place of search | Date of completion of the search | Examiner |
|---|---|---|
| Munich | 6 September 2025 | Kleppmann, Philipp |

## ANNEX TO THE EUROPEAN SEARCH REPORT
## ON EUROPEAN PATENT APPLICATION NO.

EP 25 19 2929

This annex lists the patent family members relating to the patent documents cited in the above-mentioned European search report.
The members are as contained in the European Patent Office EDP file on
The European Patent Office is in no way liable for these particulars which are merely given for the purpose of information.

06-09-2025

| Patent document cited in search report | Publication date | Patent family member(s) | Publication date |
|---|---|---|---|
| US 2023359694 A1 | 09-11-2023 | NONE | |
| EP 3674986 A1 | 01-07-2020 | CN 111352656 A | 30-06-2020 |
| | | EP 3674986 A1 | 01-07-2020 |
| | | KR 20200079059 A | 02-07-2020 |
| | | US 2020202200 A1 | 25-06-2020 |

EPO FORM P0459

For more details about this annex : see Official Journal of the European Patent Office, No. 12/82